# EUROPEAN PATENT APPLICATION

(11) **EP 4 633 020 A1**
(43) Date of publication of application: **15.10.2025**
(21) Application number: 24781002.1
(22) Date of filing: 02.02.2024
(51) Int. Cl.: H02M 1/12, H02M 1/44, H01F 17/06, H02K 11/02, H03H 7/01

(54) **ELECTRONIC DEVICE COMPRISING POWER SOURCE SUPPLY DEVICE FOR SUPPLYING POWER SOURCE TO MOTOR**

(30) Priority: 31.03.2023 KR 20230043034; 27.04.2023 KR 20230055770
(71) Applicant: Samsung Electronics Co., Ltd., Suwon-si, Gyeonggi-do 16677 (KR)
(72) Inventor: MIN, Sail, Suwon-si, Gyeonggi-do 16677 (KR); AN, Baehwan, Suwon-si, Gyeonggi-do 16677 (KR); KIM, Sooam, Suwon-si, Gyeonggi-do 16677 (KR)
(74) Representative: Gulde & Partner
(86) International application number: PCT/KR2024/001584
(87) International publication number: WO 2024/205007

(57) **Abstract**

This electronic device comprises: a motor; a power source supply device for supplying a power source to the motor; and at least one processor for controlling the motor, wherein the power source supply device includes: a power source terminal unit, which includes a ground line and receives an AC power source through a first input end, a second input end, and a third input end; an EMI filter for canceling noise included in the AC power source; and a first common mode filter which includes a ground end of the power source supply device, and a first core, and a first inductor, a second inductor and a third inductor that are wound around the first core, which uses the third inductor to connect, to the ground end, the third input end connected to the ground line, and which uses each of the first inductor and the second inductor to connect the remaining first input end and second input end to the EMI filter.

## Description

### [Technical Field]

The present disclosure relates to an electronic device, and more particularly, to an electronic device including a filter for removing noise.

### [Background Art]

An electro-magnetic interference (EMI) filter may be used to remove a noise signal occurring in a home appliance.

EMI may indicate an emitted or conducted electromagnetic wave that interferes with a function of an electronic circuit. The EMI may indicate noise. Noise may refer to unwanted electromagnetic waves.

The EMI filter may filter the noise signal occurring while power is supplied to the home appliance. If the EMI filter is used, stable power may be supplied to the home appliance. The EMI filter may be referred to as a noise filter.

The EMI filter may block, absorb, or bypass noise occurring in the home appliance.

An electrical noise signal may have various types. The noise signal may include at least one of common-mode current or differential-mode current. The common-mode current may also have various flows.

The EMI filter may be designed to correspond to conducted emission (CE). The EMI filter may remove noise occurring in a predetermined flow by design. The EMI filter may not remove noise occurring in disturbance power (DP).

### [Solution to Problem]

The present disclosure provides an electronic device for removing noise by using a common-mode filter that includes three inductors.

According to an embodiment of the present disclosure, provided is an electronic device including: a motor; a power supply device(or power source supply device) configured to supply power to the motor; and at least one processor configured to control the motor, wherein the power supply device includes a power terminal part connected to a ground wire and configured to receive an alternating current (AC) power through a first input terminal, a second input terminal, and a third input terminal, an electro magnetic interference (EMI) filter configured to remove noise included in the AC power, a ground terminal of the power supply device, and a first common-mode filter including a first core and first, second, and third inductors wound around the first core, and configured to connect the third input terminal, connected to the ground wire, to the ground terminal by using the third inductor, and to connect the remaining first and second input terminals to the EMI filter by using the first and second inductors, respectively.

The first inductor, the second inductor, and the third inductor may be connected in series.

The EMI filter may include an X capacitor section including a first capacitor, a second common-mode filter including a second core and fourth and fifth inductors wound around the second core, and a Y capacitor section including a second capacitor and a third capacitor connected in series.

The power supply device may include a first output terminal, a second output terminal, and a third output terminal, connected to the Y capacitor section.

One end of the first inductor may be connected to the first input terminal of the power terminal part, the other end of the first inductor may be connected in common to one end of the first capacitor and one end of the fourth inductor, one end of the second inductor may be connected to the second input terminal of the power terminal part, the other end of the second inductor may be connected in common to the other end of the first capacitor and one end of the fifth inductor, one end of the third inductor may be connected to the third input terminal of the power terminal part, and the other end of the third inductor may be connected in common to one end of the third capacitor and the third output terminal of the power supply device.

The other end of the fourth inductor may be connected to one end of the second capacitor and the first output terminal of the power supply device, the other end of the fifth inductor may be connected to the other end of the third capacitor and the second output terminal of the power supply device, and the other end of the third inductor may be connected to the other end of the second capacitor.

The first core may be made of a magnetic material, and the first inductor, the second inductor, and the third inductor may be wound around the first core in the same direction.

The second core may be made of a magnetic material, and the fourth inductor and the fifth inductor may be wound around the second core in the same direction.

The EMI filter may include a differential-mode filter including at least one inductor, and the differential-mode filter may be connected with the second common-mode filter and the X capacitor section.

The other end of the third inductor may be connected in common to the other end of the second capacitor, one end of the third capacitor, and the third output terminal of the power supply device via a switch.

If a predetermined event is identified as occurring, the at least one processor may be configured to turn on the switch to connect the other end of the third inductor in common to the other end of the second capacitor, one end of the third capacitor, and the third output terminal of the power supply device.

The predetermined event may be an event identified by noise greater than or equal to a threshold value.

The motor may be a brushless direct current (BLDC) motor, and may be configured to receive power passing through the EMI filter.

The device may further include a substrate on which the power terminal part, the EMI filter, and the first common-mode filter are disposed.

According to an embodiment of the present disclosure, provided is power supply device configured to supply power to a motor, the device including: a power terminal part connected to a ground wire and configured to receive an alternating current (AC) power through a first input terminal, a second input terminal, and a third input terminal; an electro magnetic interference (EMI) filter configured to remove noise included in the AC power; a ground terminal of the power supply device; and a first common-mode filter including a first core and first, second, and third inductors wound around the first core, and configured to connect the third input terminal, connected to the ground wire, to the ground terminal by using the third inductor, and to connect the remaining first and second input terminals to the EMI filter by using the first and second inductors, respectively.

### [Brief Description of Drawings]

FIG 1 is a block diagram for describing an electronic device according to an embodiment.
FIG 2 is a diagram for describing the electronic device according to an embodiment.
FIG 3 is a block diagram for describing the electronic device according to an embodiment.
FIG 4 is a diagram for describing a power supply device according to an embodiment.
FIG 5 is a diagram for describing the power supply device according to an embodiment.
FIG 6 is a diagram for describing the power supply device according to an embodiment.
FIG 7 is a diagram for describing the power supply device according to an embodiment.
FIG 8 is a diagram for describing the power supply device according to an embodiment.
FIG 9 is a diagram for describing the power supply device according to an embodiment.
FIG 10 is a diagram for describing the power supply device according to an embodiment.
FIG 11 is a diagram for describing the power supply device according to an embodiment.
FIG 12 is a diagram for describing an operation for providing noise information.
FIG 13 is a diagram for describing a noise path.
FIG 14 is a diagram for describing an arrangement of an electro-magnetic interference (EMI) filter.
FIG 15 is a diagram for describing an EMI filter that does not include a three-terminal common-mode filter and the disturbance current according to an embodiment.
FIG 16 is a diagram for describing an EMI filter 140 that includes a three-terminal common-mode filter and the disturbance current according to an embodiment.
FIG 17 is a diagram for describing a second common-mode filter 142.
FIG 18 is a diagram for describing a first common-mode filter 130.
FIG 19 is a diagram for describing equipment under test (EUT) and a line impedance stabilization network (LISN).
FIG 20 is a diagram for describing the line impedance stabilization network.
FIG 21 is a diagram for describing the disturbance current flowing through the equipment under test and the line impedance stabilization network.
FIG 22 is a diagram for describing the EMI filter and the disturbance current according to an embodiment.
FIG 23 is a diagram for describing the EMI filter and the disturbance current according to an embodiment.
FIG 24 is a diagram for describing an operation for measuring the disturbance power.
FIG 25 is a diagram for describing an absorption clamp.
FIG 26 is a diagram for describing noise occurring if the line impedance stabilization network is used.
FIG 27 is a diagram for describing noise occurring if the absorption clamp is used.

### [Mode for the Invention]

It should be understood that various embodiments of the present disclosure and terms used herein are not intended to limit technical features described in the present disclosure to specific embodiments, and rather are intended to include various modifications, equivalents, and substitutions of the corresponding embodiments.

Throughout the accompanying drawings, similar components are denoted by similar reference numerals.

A singular noun corresponding to an item is intended to include one or more of the items unless a relevant context clearly indicates otherwise.

In the present disclosure, an expression such as "A or B", "at least one of A and B", "at least one of A or B", "A, B, or C", "at least one of A, B, and C", "at least one of A, B, or C", or the like may include any one of the items listed together or all possible combinations thereof.

A term "and/or" includes a combination of a plurality of related items or any one of the plurality of related items.

Terms such as "first", "second", or the like may be used simply to distinguish one element and another element from each other, and do not limit the corresponding components in any other respect (e.g., importance or order).

In case that a component (for example, a first component) is mentioned to be "coupled with/to" or "connected to" another component (for example, a second component) with or without terms "operatively or communicatively", it should be understood that the component may be directly coupled to another component (e.g., in a wired manner), in a wireless manner, or through a third component).

It should be further understood that terms "include", "have" or the like, used in the specification specify the presence of features, numerals, steps, operations, components, parts mentioned in the specification or combinations thereof, and do not preclude the presence or addition of one or more other features, numerals, steps, operations, components, parts, or combinations thereof.

In that a component is referred to as being "connected", "coupled", "supported", or "in contact" with another component, it includes not only a case where the components are directly connected, coupled, supported, or in contact with each other, but also a case where the components are indirectly connected, coupled, supported, or in contact with each other through a third component.

In case that a component is referred to be disposed "on" another component, it includes not only a case where the component is in contact with another component, but also a case where still another component is interposed between the two components.

An air conditioner according to various embodiments refers to a device that performs a function of air purification, ventilation, humidity adjustment, cooling, or heating in an air-conditioned space (hereinafter referred to as "indoor space"), and has at least one of these functions.

According to an embodiment, the air conditioner may include a heat pump device to perform the cooling function or the heating function. The heat pump device may include a refrigeration cycle in which a refrigerant is circulated along a compressor, a first heat exchanger, an expansion device, and a second heat exchanger. All components of the heat pump device may be embedded in a single housing configuring an outer appearance of the air conditioner, and a window air conditioner or a portable air conditioner may correspond to the air conditioner. On the other hand, some components of the heat pump device may be embedded separately in a plurality of housings included in a single air conditioner, and a wall-mounted air conditioner, a stand-alone air conditioner, a system air conditioner, or the like may be included in the air conditioner.

The air conditioner including the plurality of housings may include at least one outdoor unit installed outdoors and at least one indoor unit installed indoors. For example, the air conditioner may include one outdoor unit and one indoor unit connected to each other through a refrigerant pipe. For example, the air conditioner may include one outdoor unit connected to two or more indoor units through the refrigerant pipe. For example, the air conditioner may include two or more outdoor units and two or more indoor units connected to each other through the plurality of refrigerant pipes.

The outdoor unit may be electrically connected to the indoor unit. For example, information (or a command) for controlling the air conditioner may be input through an input interface disposed on the outdoor unit or the indoor unit, and the outdoor unit and the indoor unit may be operated simultaneously or sequentially in response to user input.

The air conditioner may include an outdoor heat exchanger disposed in the outdoor unit, an indoor heat exchanger disposed in the indoor unit, and the refrigerant pipe connecting the outdoor heat exchanger to the indoor heat exchanger.

The outdoor heat exchanger may perform heat exchange between the refrigerant and outdoor air by utilizing a phase change (e.g., evaporation or condensation) of the refrigerant. For example, while the refrigerant condenses in the outdoor heat exchanger, the refrigerant may release heat to the outdoor air, and while the refrigerant flowing in the outdoor heat exchanger evaporates, the refrigerant may absorb heat from the outdoor air.

The indoor unit may be installed indoors. For example, the indoor unit may be classified into a ceiling-type indoor unit, a stand-alone indoor unit, and a wall-mounted indoor unit based on an arrangement method. For example, the ceiling-type indoor unit may be classified into a four-way indoor unit, a one-way indoor unit, and a duct-type indoor unit based on an air discharge method.

Similarly, the indoor heat exchanger may perform heat exchange between the refrigerant and indoor air by utilizing the phase change (e.g., evaporation or condensation) of the refrigerant. For example, while the refrigerant evaporates in the indoor unit, the refrigerant may absorb heat from the indoor air, and the indoors may be cooled by blowing the cooled indoor air through the cooled indoor heat exchanger. While the refrigerant condenses in the indoor heat exchanger, the refrigerant may release heat to the indoor air, and the indoors may be heated by blowing the heated indoor air while passing through the high-temperature indoor heat exchanger.

That is, the air conditioner may perform the cooling or heating function through a phase change process of the refrigerant circulated between the outdoor heat exchanger and the indoor heat exchanger. For the refrigerant circulation, the air conditioner may include the compressor for compressing the refrigerant. The compressor may inhale a refrigerant gas through a suction part and compress the refrigerant gas. The compressor may discharge the high-temperature and high-pressure refrigerant gas through a discharge part. The compressor may be disposed inside the outdoor unit.

The refrigerant may be circulated through the refrigerant pipe in an order of the compressor, the outdoor heat exchanger, the expansion device, and the indoor heat exchanger, or in an order of the compressor, the indoor heat exchanger, the expansion device, and the outdoor heat exchanger.

For example, if the air conditioner has one outdoor unit and one indoor unit directly connected to each other through the refrigerant pipe, the refrigerant may be circulated between the outdoor unit and the indoor unit through the refrigerant pipe.

For example, if the air conditioner has one outdoor unit connected to two or more indoor units through the refrigerant pipe, the refrigerant may flow into the plurality of indoor units through the refrigerant pipes branching from the outdoor unit. The refrigerants discharged from the plurality of indoor units may be merged and circulated to the outdoor unit. For example, the plurality of indoor units may be directly connected in parallel to one outdoor unit through separate refrigerant pipes.

The plurality of indoor units may be operated independently based on an operation mode set by a user. That is, some of the plurality of indoor units may be operated in the cooling mode and others may be operated in the heating mode simultaneously. Here, the refrigerant may be selectively introduced into each of the indoor units in a high or low pressure state along a designated circulation path through a flow path switching valve described below, and discharged and circulated to the outdoor unit. For example, the air conditioner may be configured to have two or more

For example, if the air conditioner has two or more outdoor units and two or more indoor units connected to each other through the plurality of refrigerant pipes, the refrigerants discharged from the plurality of outdoor units may merge and flow through one refrigerant pipe, and then be branched at some point to be introduced to the plurality of indoor units.

The plurality of outdoor units may be driven entirely or at least partially, depending on an operation load of the plurality of indoor units that is caused by their operation capacity. In this case, the refrigerant may be introduced and circulated to the outdoor unit selectively driven by the flow path switching valve. The air conditioner may include the expansion device to reduce a pressure of the refrigerant introduced to the heat exchanger. For example, the expansion device may be disposed inside either the indoor unit or the outdoor unit, or may be disposed in both the indoor unit and the outdoor unit.

The expansion device may lower the temperature and pressure of the refrigerant by using a throttling effect, for example. The expansion device may include an orifice that may reduce a cross-sectional area of the flow path. The refrigerant passing through the orifice may lower its temperature and pressure.

The expansion device may be implemented as an electronic expansion valve, for example, which may adjust an opening ratio (a ratio of the cross-sectional area of the flow path of the valve in a partially open state to the cross-sectional area of the flow path of the valve in a fully open state). An amount of refrigerant passing through the expansion device may be controlled depending on the opening ratio of the electronic expansion valve.

The air conditioner may further include the flow path switching valve disposed on a refrigerant circulation flow path. The flow path switching valve may include, for example, a four-way valve. The flow path switching valve may determine(or switch) the refrigerant circulation path depending on the operation mode of the indoor unit (e.g., a cooling operation or a heating operation). The flow path switching valve may be connected to the discharge part of the compressor.

The air conditioner may include an accumulator. The accumulator may be connected to the suction part of the compressor. The low-temperature and low-pressure refrigerant evaporated from the indoor heat exchanger or the outdoor heat exchanger may be introduced into the accumulator.

The accumulator may separate a liquid refrigerant from the refrigerant gas if the refrigerant, which is a mixture of the liquid refrigerant and the refrigerant gas, is introduced into the accumulator, and provide the refrigerant gas, from which the liquid refrigerant is separated, to the compressor.

An outdoor fan may be disposed near the outdoor heat exchanger. The outdoor fan may blow the outdoor air to the outdoor heat exchanger to promote heat exchange between the refrigerant and the outdoor air.

The outdoor unit of the air conditioner may include at least one sensor. For example, an outdoor unit sensor may be an environmental sensor. The outdoor unit sensor may be disposed at any position inside or outside the outdoor unit. For example, the outdoor unit sensor may include a temperature sensor for detecting an air temperature around the outdoor unit, a humidity sensor for detecting an air humidity around the outdoor unit, or a refrigerant temperature sensor for detecting the refrigerant temperature in the refrigerant pipe passing through the outdoor unit, or a refrigerant pressure sensor for detecting the refrigerant pressure in the refrigerant pipe passing through the outdoor unit.

The outdoor unit of the air conditioner may include an outdoor unit communication device. The outdoor unit communication device may receive a control signal from an indoor unit controller of the air conditioner described below. The outdoor unit may control the operation of the compressor, the outdoor heat exchanger, the expansion device, the flow path switching valve, the accumulator, or the outdoor fan based on the control signal received through the outdoor unit communication device. The outdoor unit may transmit a sensed value detected from the outdoor unit sensor to an indoor unit controller through the outdoor unit communication device.

The indoor unit of the air conditioner may include a housing, a blower for circulating air into or out of the housing, and the indoor heat exchanger for exchanging heat with the air introduced into the housing.

The housing may include an intake port through which the indoor air may be introduced into the housing.

The indoor unit of the air conditioner may include a filter for filtering out a foreign material in air introduced into the housing through the intake port.

The housing may include a discharge port. Air flowing inside the housing may be discharged to the outside of the housing through the discharge port.

The housing of the indoor unit may include an airflow guide that guides a direction of air discharged through the discharge port. As an example, the airflow guide may include a blade disposed on the discharge port. As an example, the airflow guide may include an auxiliary fan for adjusting a discharged airflow. The present disclosure/housing is not limited thereto, and the airflow guide may be omitted.

The indoor heat exchanger and blower may be disposed inside the housing of the indoor unit and disposed on a flow path connecting the intake port to the discharge port.

The blower may include an indoor fan and a fan motor. For example, the indoor fan may include an axial fan, a diffusion fan, a crossflow fan, or a centrifugal fan.

The indoor heat exchanger may be disposed between the blower and the discharge port, or between the intake port and the blower. The indoor heat exchanger may absorb heat from air introduced through the intake port, or transfer heat to air introduced through the intake port. The indoor heat exchanger may include a heat exchange tube through which the refrigerant flows, and a heat exchange fin in contact with the heat exchange tube to increase a heat transfer area.

The indoor unit of the air conditioner may include a drain tray disposed below the indoor heat exchanger to collect condensate occurring in the indoor heat exchanger. The condensate accommodated in the drain tray may be drained to the outside through a drain hose. The drain tray may support the indoor heat exchanger.

The indoor unit of the air conditioner may include an input interface. The input interface may include any type of user input members including a button, a switch, a touchscreen, and/or a touch pad. The user may directly input setting data (e.g., desired indoor temperature, operation mode setting for cooling/heating/dehumidification/air purification, discharge port selection setting, and/or air flow setting) through the input interface.

The input interface may be connected to an external input device. For example, the input interface may be electrically connected to a wired remote controller. The wired remote controller may be installed at a specific position in an indoor space (e.g., a portion of a wall surface). The user may input setting data regarding the operation of the air conditioner by manipulating the wired remote controller. An electrical signal corresponding to the setting data obtained through the wired remote controller may be transmitted to the input interface. The input interface may include an infrared sensor. The user may input setting data regarding the operation of the air conditioner remotely by using a wireless remote controller. The setting data input through the wireless remote controller may be transmitted to the input interface as an infrared signal.

The input interface may include a microphone. A user voice command may be obtained through the microphone. The microphone may convert the user voice command into the electrical signal and transfer the converted electrical signal to the indoor unit controller. The indoor unit controller may control the component of the air conditioner to execute a function corresponding to the user voice command. The setting data (e.g., the desired indoor temperature, the operation mode setting for cooling/heating/dehumidification/air purification, the discharge port selection setting, and/or the air flow setting) obtained through the input interface may be transferred to the indoor unit controller as described below. For example, the setting data obtained through the input interface may be transmitted externally, i.e., to the outdoor unit or a server, through an indoor unit communication device described below.

The indoor unit of the air conditioner may include a power module. The power module may be connected to the external power supply to supply power to the components of the indoor unit.

The indoor unit of the air conditioner may include an indoor unit sensor. The indoor unit sensor may be an environmental sensor disposed in a space inside or outside the housing. As an example, the indoor unit sensor may include at least one temperature sensor and/or humidity sensor disposed in a predetermined space inside or outside the housing of the indoor unit. As an example, the indoor unit sensor may include the refrigerant temperature sensor for detecting the refrigerant temperature in the refrigerant pipe passing through the indoor unit. As an example, the indoor unit sensor may include each refrigerant temperature sensor for detecting the inlet, middle, and/or outlet temperatures of the refrigerant pipe passing through the indoor heat exchanger.

As an example, each environmental information detected by/using/from the indoor unit sensor may be transferred to the indoor unit controller described below, or transmitted externally through the indoor unit communication device described below.

The indoor unit of the air conditioner may include the indoor unit communication device. The indoor unit communication device may include at least one of a short-range communication module or a long-range communication module. The indoor unit communication device may include at least one antenna for communicating with another device in a wireless manner. The outdoor unit may include the outdoor unit communication device. The outdoor unit communication device may also include at least one of the short-range communication module or the long-range communication module.

The short-range communication module (or a short-range wireless communication module) may include, a Bluetooth communication module, a Bluetooth low energy (BLE) communication module, a near field communication module, a wireless local area network (WLAN) communication module, a Zigbee communication module, an infrared data association (IrDA) communication module, a Wi-Fi direct (WFD) communication module, a ultrawideband (UWB) communication module, an Ant+ communication module, a microwave (uWave) communication module, or the like, and is not limited to.

The long-range communication module may include a communication module that performs various types of long-range communication and may include a mobile communication device. The mobile communication device may transmit and receive a wireless signal to and from at least one of a base station, an external terminal, and a server through a mobile communication network.

The indoor unit communication device may communicate with the external device such as the server, the mobile device, or another home appliance through a surrounding access point (AP). The access point (AP) may connect a local area network (LAN) to which the air conditioner or a user device is connected to a wide area network (WAN) to which the server is connected. The air conditioner or the user device may be connected to the server through the wide area network (WAN). The indoor unit of the air conditioner may include the indoor unit controller that controls the components of the indoor unit, including a blower and the like. The outdoor unit of the air conditioner may include the outdoor unit controller that controls the components of the outdoor unit including the compressor and the like. The indoor unit controller may communicate with the outdoor unit controller through the indoor unit communication device or the outdoor unit communication device. The outdoor unit communication device may transmit the control signal generated by the outdoor unit controller to the indoor unit communication device, or transfer the control signal transmitted from the indoor unit communication device to the outdoor unit controller. That is, the outdoor unit and the indoor unit may perform two-way communication. The outdoor unit and the indoor unit may transmit and receive various signals generated during the operation of the air conditioner.

The outdoor unit controller may be electrically connected to the components of the outdoor unit, and may control the operation of each component. For example, the outdoor unit controller may adjust a frequency of the compressor, and control the flow path switching valve to switch a refrigerant circulation direction. The outdoor unit controller may adjust a rotation speed of the outdoor fan. The outdoor unit controller may generate a control signal to adjust an opening degree of the expansion valve. Under the control of the outdoor unit controller, the refrigerant may be circulated along a refrigerant circulation circuit including the compressor, the flow path switching valve, the outdoor heat exchanger, the expansion valve, and the indoor heat exchanger.

The various temperature sensors included in the outdoor and indoor units may transmit the electrical signals corresponding to the detected temperatures to the outdoor unit controller and/or the indoor unit controller, respectively. For example, the humidity sensors included in the outdoor and indoor units may transmit electrical signals corresponding to the detected humidity to the outdoor unit controller and/or the indoor unit controller, respectively.

The indoor unit controller may obtain the user input from the user device, including a mobile device, through the indoor unit communication device, and may obtain the user input directly through the input interface or through the remote controller. The indoor unit controller may control the components of the indoor unit, including the blower, in response to the received user input. The indoor unit controller may transmit information on the received user input to the outdoor unit controller of the outdoor unit.

The outdoor unit controller may control the components of the outdoor unit, including the compressor, based on the information on the user input received from the indoor unit. For example, if the outdoor unit controller receives the control signal from the indoor unit that corresponds to the user input for selecting an operation mode, such as the cooling operation, the heating operation, a blowing operation, a defrost operation, or a dehumidification operation, the outdoor unit controller may control the components of the outdoor unit to perform the operation of the air conditioner corresponding to the selected operation mode.

Each of the outdoor unit controller and the indoor unit controller may include a processor and a memory. The indoor unit controller may include at least one first processor and at least one first memory, and the outdoor unit controller may include at least one second processor and at least one second memory.

The memory may remember/store various information necessary for the operation of the air conditioner. The memory may store instructions, applications, data, and/or programs necessary for the operation of the air conditioner. For example, the memory may store various programs for the cooling operation, heating operation, dehumidification operation, and/or defrost operation of the air conditioner. The memory may include a volatile memory such as a static random access memory (S-RAM) and a dynamic random access memory (D-RAM) for temporarily storing data. The memory may include a nonvolatile memory such as a read only memory (ROM), an erasable programmable read only memory (EPROM), or an electrically erasable programmable read only memory (EEPROM) for long-term storage of data.

The processor may generate the control signal for controlling the operation of the air conditioner based on the instructions, the applications, the data and/or the programs stored in the memory. The processor may include logic circuits and arithmetic circuits as hardware. The processor may process data based on the program and/or instructions provided from the memory and generate the control signal based on a processing result. The memory and the processor may be implemented in one control circuit or the plurality of circuits.

The indoor unit of the air conditioner may include an output interface. The output interface may be electrically connected to the indoor unit controller and may output information related to the operation of the air conditioner under the control of the indoor unit controller. For example, information such as the operation mode, a wind direction, a wind volume, and a temperature selected by the user input may be output. The output interface may output sensing information obtained from the indoor unit sensor or the outdoor unit sensor, and warning/error messages.

The output interface may include a display and a speaker. The speaker may output various sounds as an audio device. The display may display information input by the user or information provided to the user by using various graphic elements. For example, operation information of the air conditioner may be displayed as at least one of an image or text. The display may include an indicator that provides specific information. The display may include a liquid crystal display panel (LCD) panel, a light emitting diode (LED) panel, an organic light emitting diode (OLED) panel, a micro LED panel, and/or a plurality of LEDs.

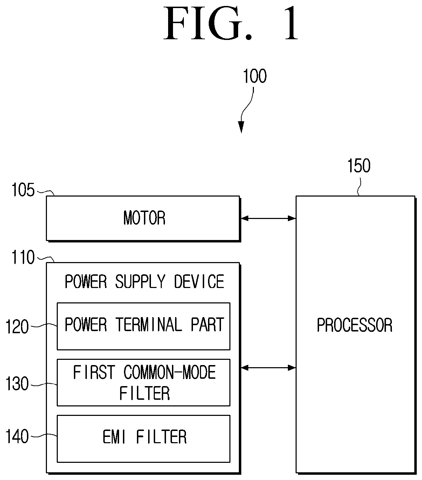

FIG 1 is a block diagram for describing an electronic device 100 according to an embodiment.

Referring to FIG 1, the electronic device 100 may include at least one of a motor 105, a power supply device 110, or at least one processor 150.

The power supply device 110 may include at least one of a power terminal part 120, a first common-mode filter 130, or an electro-magnetic interference (EMI) filter 140.

The motor 105 may generate power to drive the electronic device 100. The motor 105 may generate noise.

The EMI filter 140 may absorb or remove noise.

At least one processor 150 may perform overall operations performed by the electronic device 100.

The electronic device 100 may include the motor 105, the power supply device 110 for supplying power to the motor 105, and at least one processor 150 for controlling the motor 105.

The power supply device 110 may include the power terminal part 120 connected to a ground wire and receiving external power (e.g., alternating current (AC) power) through a first input terminal Li, a second input terminal Ni, and a third input terminal Ei.

The power supply device 110 may include the EMI filter 140 for removing noise included in the external power (e.g., the AC power).

Noise may occur if the external power is supplied. Noise may be an unwanted electromagnetic wave occurring if the external power is supplied. Noise may be referred to as a noise signal.

The power supply device 110 may include a ground terminal of the power supply device 110, a first core 1801, and first, second, and third inductors L1, L2, and L3 wound around the first core 1801, and may include the first common-mode filter 130 for connecting the third input terminal Ei, connected to the ground wire, to the ground terminal by using the third inductor L3, and connecting the remaining first and second input terminals Li and Ni to the EMI filter 140 by using the first and second inductors L1 and L2, respectively.

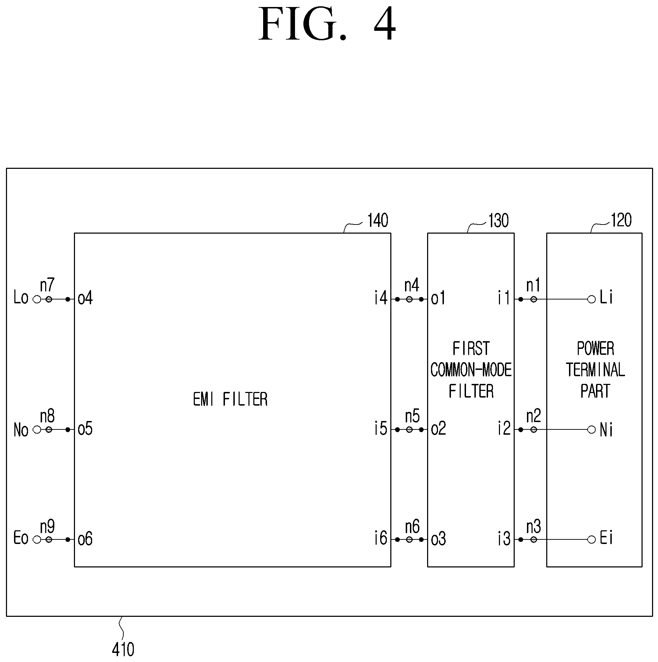

Descriptions of the power terminal part 120, the first common-mode filter 130, and the EMI filter 140 included in the power supply device 110 are provided with reference to FIG 4.

The external power supply (e.g., AC power supply) may be a single-phase alternating current power supply.

The common-mode filter may be referred to as a common-mode choke, a common-mode coil, a common-mode choke coil, a noise filter, an inductor part, or the like.

The first common-mode filter 130 may remove a common-mode current, i.e., noise occurring in the power.

The first common-mode filter 130 may be a three-terminal common-mode choke coil (or a common mode choking coil). Three terminals may indicate three pairs of terminals. For example, the three-terminal first common-mode filter 130 may include three input terminals and three output terminals. The first common-mode filter 130 may include a total of six terminals.

The first inductor L1, the second inductor L2, and the third inductor L3 may be connected in series.

The first common-mode filter 130 may be connected to the power terminal part 120. The first inductor L1 may be connected to the first input terminal Li. The second inductor L2 may be connected to the second input terminal Ni. The third inductor L3 may be connected to the third input terminal Ei.

The first common-mode filter 130 may be connected to the EMI filter 140.

The EMI filter 140 may be connected to the first output terminal Lo, second output terminal No and third output terminal Eo of the power supply device 110.

The power terminal part 120, the first common-mode filter 130, and the EMI filter 140 may be connected.

The EMI filter 140 may include an X capacitor section 141 including a first capacitor C1.

The EMI filter 140 may include the second common-mode filter 142 including a second core 1701 and fourth and fifth inductors L4 and L5 wound around the second core 1701.

The EMI filter 140 may include a Y capacitor section 143 including a second capacitor C2 and a third capacitor C3 connected in series.

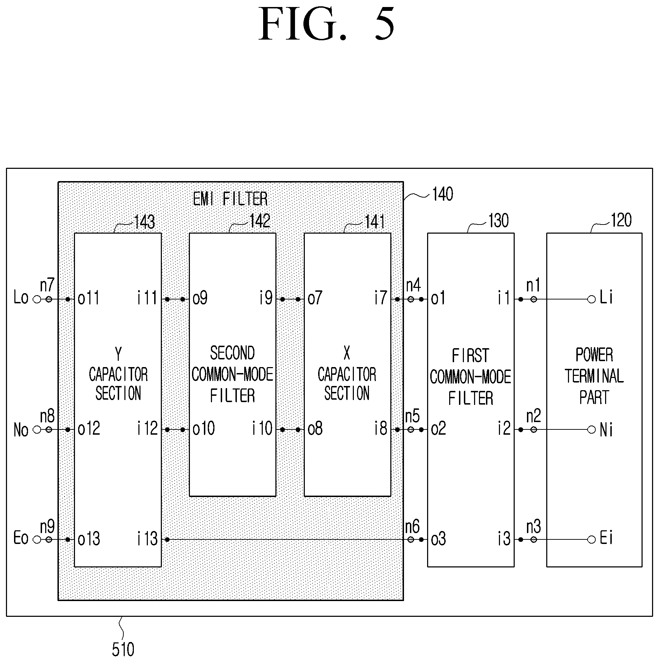

Descriptions of the X capacitor section 141, the second common-mode filter 142, and the Y capacitor section 143, included in EMI filter 140, are provided with reference to FIG 5.

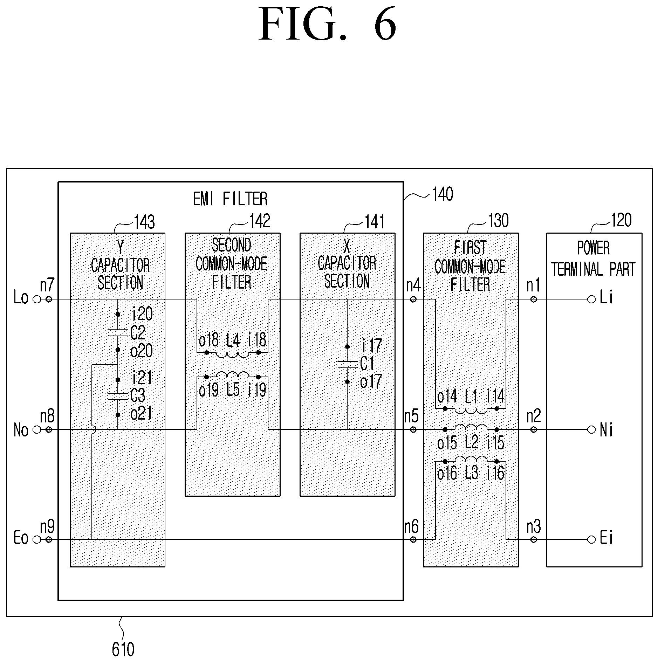

Descriptions of components included in X capacitor section 141, the second common-mode filter 142, and Y capacitor section 143 are provided with reference to FIG 6.

The power supply device 110 may include the first output terminal Lo, the second output terminal No, and the third output terminal Eo, connected to the Y capacitor section 143.

One end i14 of the first inductor L1 may be connected to the first input terminal Li of the power terminal part 120.

The other end o14 of the first inductor L1 may be connected in common to one end i17 of the first capacitor C1 and one end i18 of the fourth inductor L4.

One end i15 of the second inductor L2 may be connected to the second input terminal Ni of the power terminal part 120.

The other end o15 of the second inductor L2 may be connected in common to the other end o17 of the first capacitor C1 and one end i19 of the fifth inductor L5.

One end i16 of the third inductor L3 may be connected to the third input terminal Ei of the power terminal part 120.

The other end o16 of the third inductor L3 may be connected in common to other end o20 of the second capacitor, one end i21 of the third capacitor C3, and the third output terminal Eo of the power supply device 110.

The other end o18 of the fourth inductor L4 may be connected to one end i20 of the second capacitor C2 and the first output terminal Lo of the power supply device 110.

The other end o19 of the fifth inductor L5 may be connected to the other end o21 of the third capacitor C3 and the second output terminal No of the power supply device 110.

The first core 1801 may be made of a magnetic material.

The first inductor L1, the second inductor L2, and the third inductor L3 may be wound around the first core 1801 in the same direction.

A winding 1811 of the first inductor L1, a winding 1812 of the second inductor L2, and a winding 1813 of the third inductor L3 may be wound around the first core 1801 in the same direction.

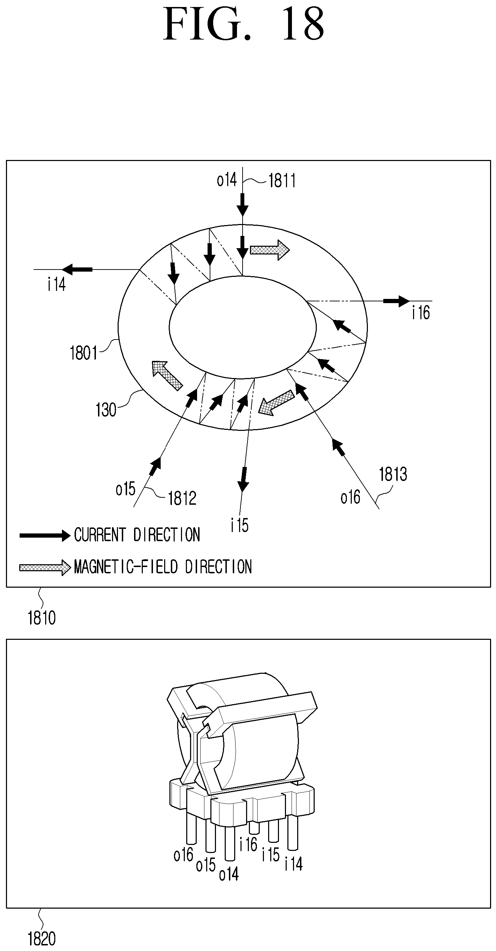

A description of the first core 1801 is provided with reference to FIG 18.

The second core 1701 may be made of a magnetic material.

The fourth inductor L4 and the fifth inductor L5 may be wound around the second core 1701 in the same direction.

A winding 1711 of the fourth inductor L4 and a winding 1712 of the fifth inductor L5 may be wound around the second core 1701 in the same direction.

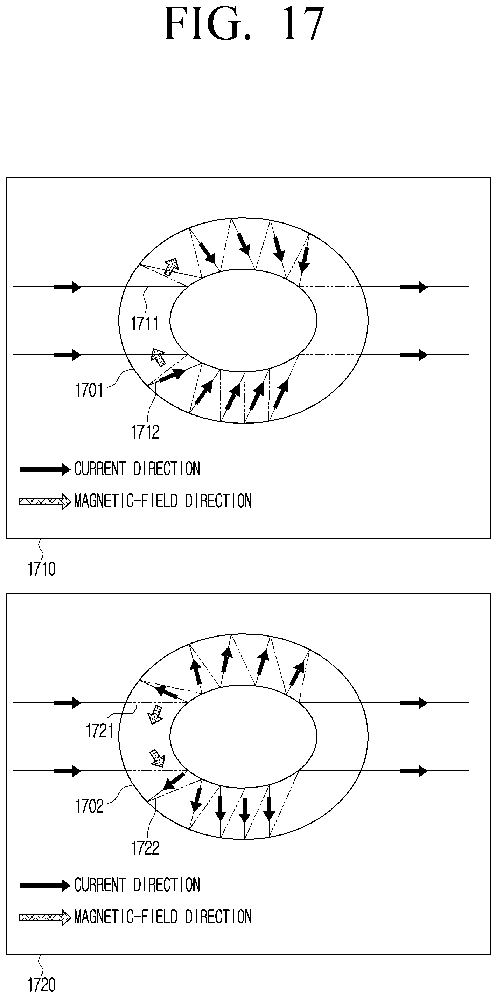

A description of the second core 1701 is provided with reference to FIG. 17.

The EMI filter 140 may include a differential-mode filter 144 including at least one inductor.

The differential-mode filter 144 may be connected with the second common-mode filter 142 and the X capacitor section 141.

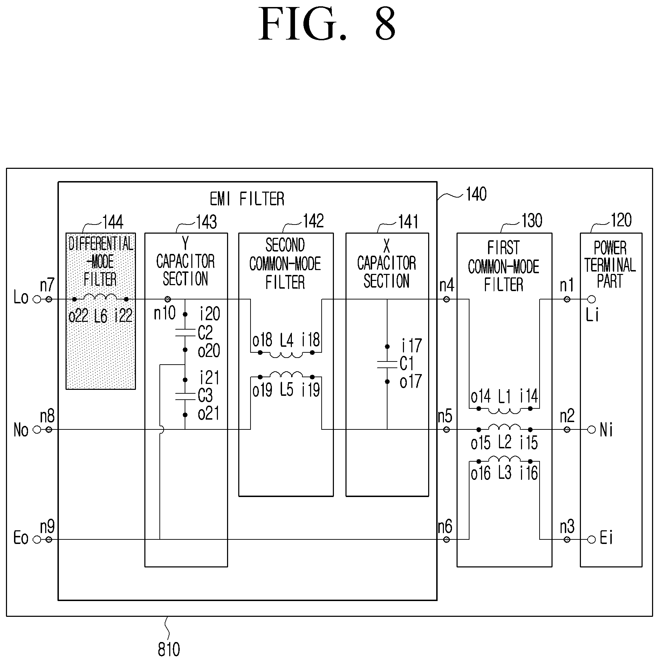

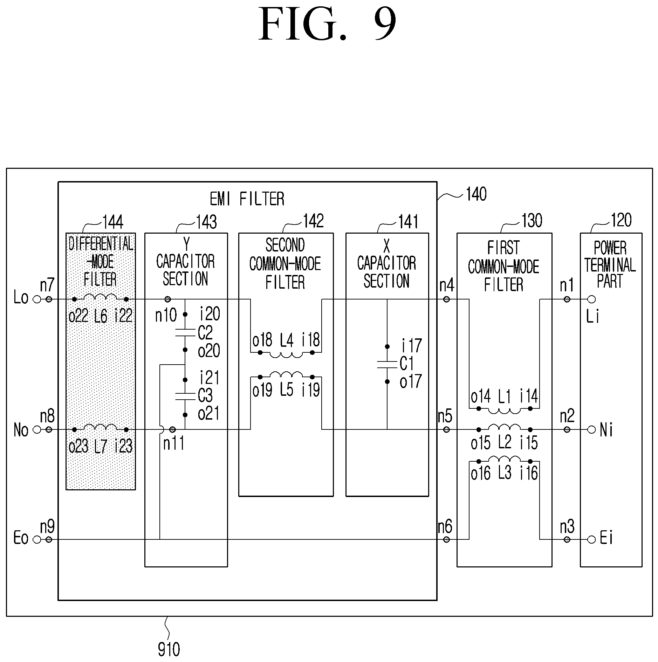

A detailed description of the differential-mode filter 144 is provided with reference to FIGS. 8 and 9.

The differential-mode filter 144 may remove a differential-mode current, which is noise occurring in power.

The other end o16 of the third inductor L3 may be connected in common to the other end o20 of the second capacitor, one end i21 of the third capacitor C3, and the third output terminal Eo of the power supply device 110 via a switch S1.

If a predetermined event is identified as occurring, at least one processor 150 may turn on the switch S1 to electrically connect the other end o16 of the third inductor L3 in common to the other end o20 of the second capacitor C2, one end i21 of the third capacitor C3, and the third output terminal Eo of the power supply device 110.

The predetermined event may be an event identified by noise greater than or equal to a threshold value.

As an example, the predetermined event may be an event in which a noise current magnitude is identified as being greater than or equal to a first threshold value.

As an example, the predetermined event may be an event in which a noise voltage magnitude is identified as being greater than or equal to a second threshold value.

As an example, the predetermined event may be an event in which the noise current magnitude is identified as being greater than or equal to the first threshold value or the noise voltage magnitude is identified as being greater than or equal to the second threshold value.

As an example, the predetermined event may be an event in which the noise current magnitude is identified as being greater than or equal to the first threshold value and the noise voltage magnitude is identified as being greater than or equal to the second threshold value.

At least one processor 150 may obtain at least one of the noise current or the noise voltage by measuring noise.

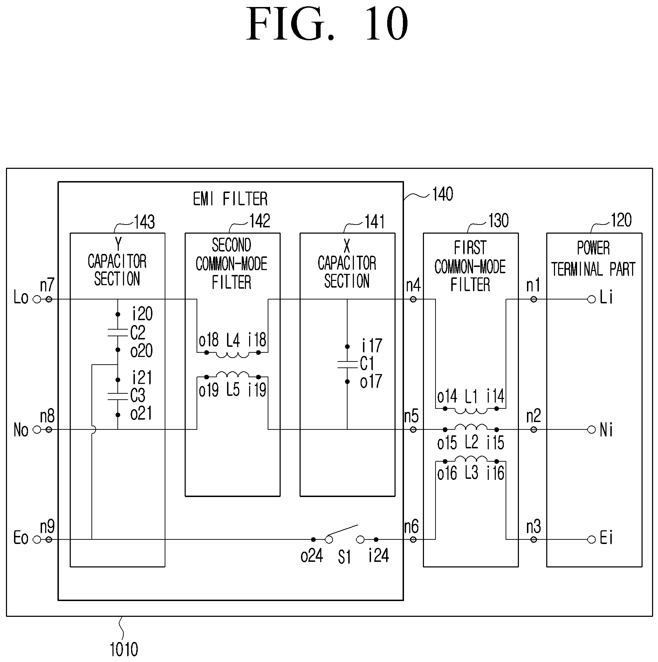

Methods for measuring the noise current and the noise voltage are described with reference to FIG 10.

A detailed description of the switch S1 is provided with reference to FIG. 10.

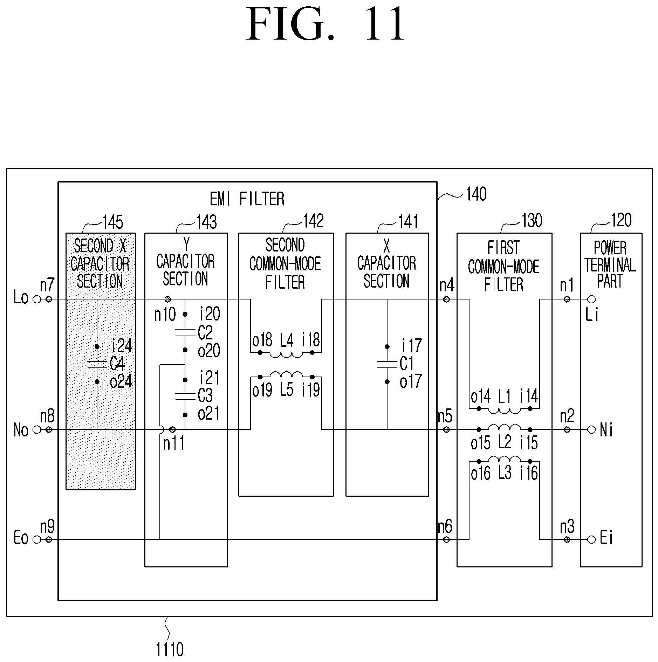

A description of a second X capacitor section 145 additionally included in the EMI filter 140 is provided with reference to FIG 11.

The motor 105 may be a brushless direct current (BLDC) motor, an alternating current (AC) motor, or a compressor.

The BLDC motor may indicate a direct current (DC) motor rotated without a brush inside the motor. The AC motor may indicate a motor rotated using alternating current power. The compressor may be a device for reducing a gas volume and increasing a gas pressure. The motor 105 may receive, as input, power passing through the EMI filter 140. The motor 105 may receive power passing through the EMI filter 140.

The electronic device 100 may further include a substrate on which the power terminal part 120, the EMI filter 140, and the first common-mode filter 130 are disposed.

As an example, the substrate on which the power terminal part 120, the EMI filter 140, and the first common-mode filter 130 are disposed may be a substrate of the power supply device 110. A separate substrate of the electronic device 100 may be provided. The substrate of the electronic device 100 may include at least one processor 150. The substrate of the electronic device 100 may be referred to as a main board.

As an example, the substrate on which the power terminal part 120, the EMI filter 140, and the first common-mode filter 130 are disposed may be the substrate of the electronic device 100.

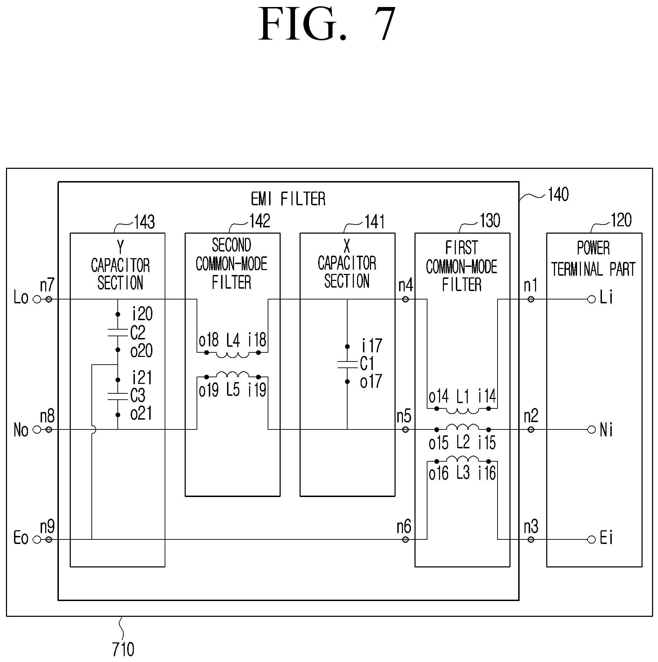

The first common-mode filter 130 may be described as a separate component from the EMI filter 140. According to an implementation example, the first common-mode filter 130 may be included in the EMI filter 140. A detailed description thereof is provided with reference to FIG 7.

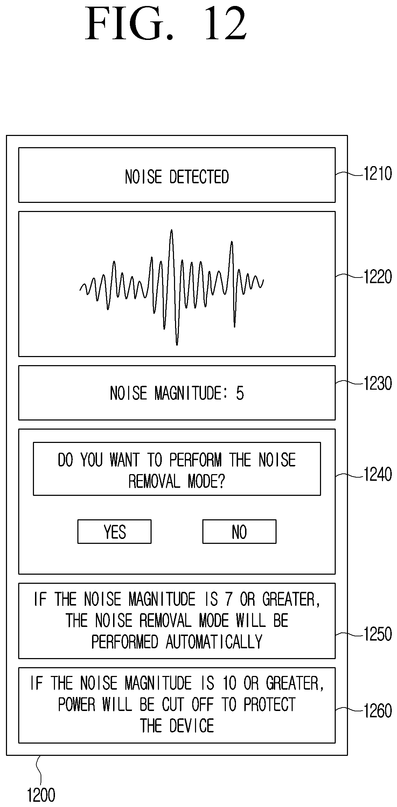

A guide screen regarding noise may be provided to a user. A detailed description thereof is described is provided with reference to FIG 12.

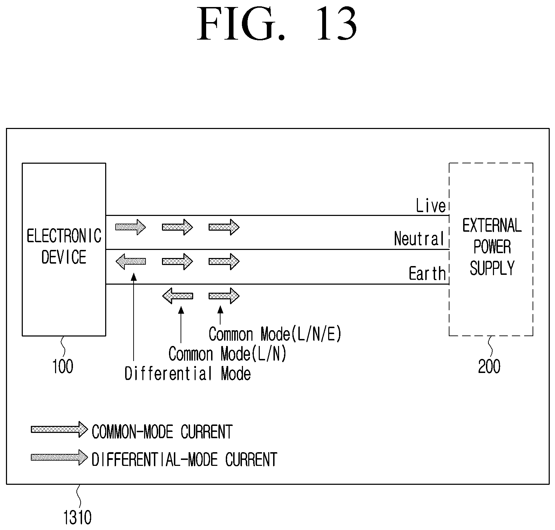

Descriptions of the common-mode current and the differential-mode current are provided with reference to FIG 13.

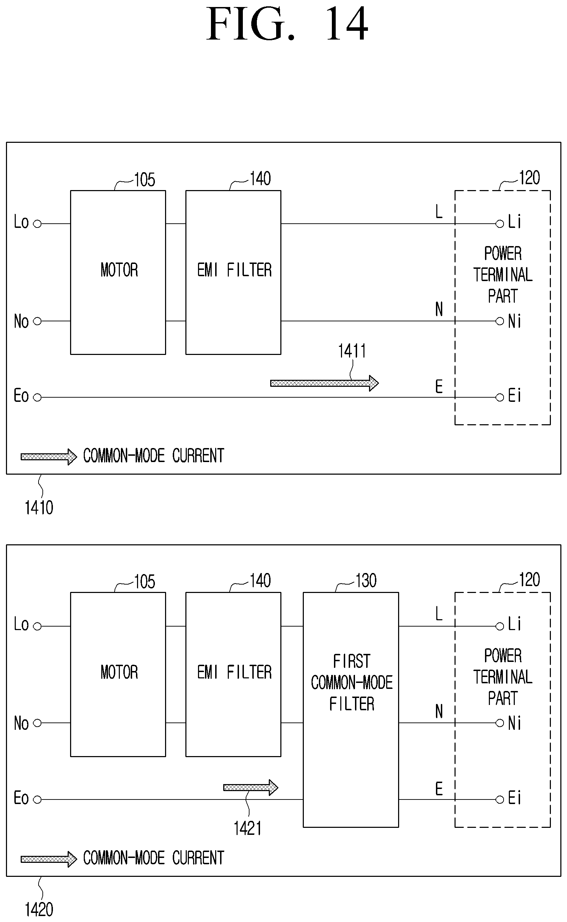

According to an embodiment, a connection relationship among the motor 105, the first common-mode filter 130, and the EMI filter 140 is described with reference to FIG 14.

A flow of the common-mode current in the power supply device 110 that does not include the first common-mode filter 130 is described with reference to FIG. 14.

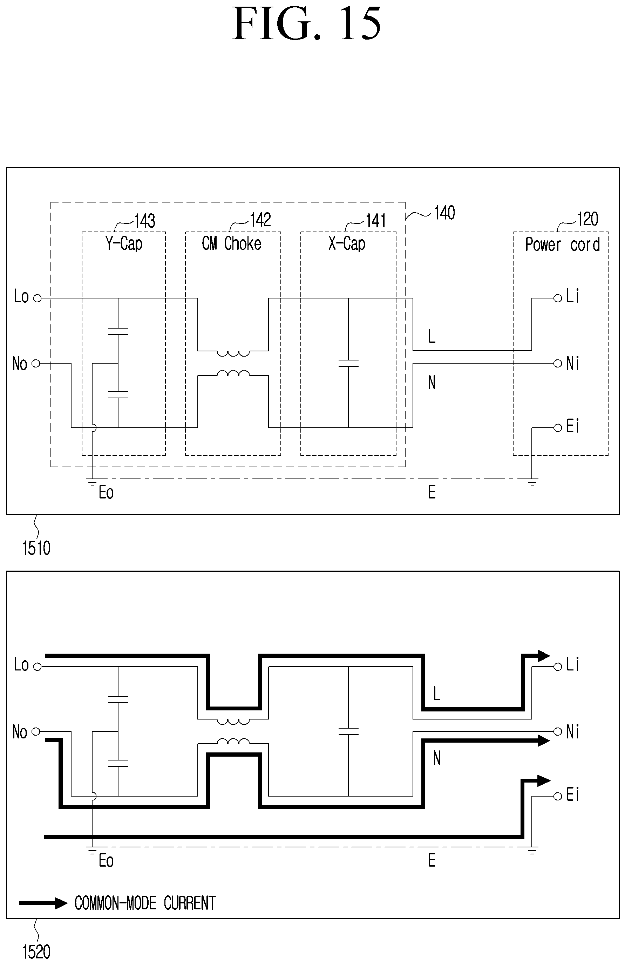

A flow of the common-mode current in the power supply device 110 that includes the first common-mode filter 130 is described with reference to FIG. 15.

A detailed description of noise is provided with reference to FIGS. 13, 14, 15, 16, 21, 22, 23, 26 and 27.

The power supply device 110 may include the first common-mode filter 130. The first common-mode filter 130 may include three inductors. The noise current flowing from the third output terminal Eo of the power supply device 110 to the third input terminal Ei of the power supply device 110 may be removed (or limited) by using the third inductor L3 included in the first common-mode filter 130.

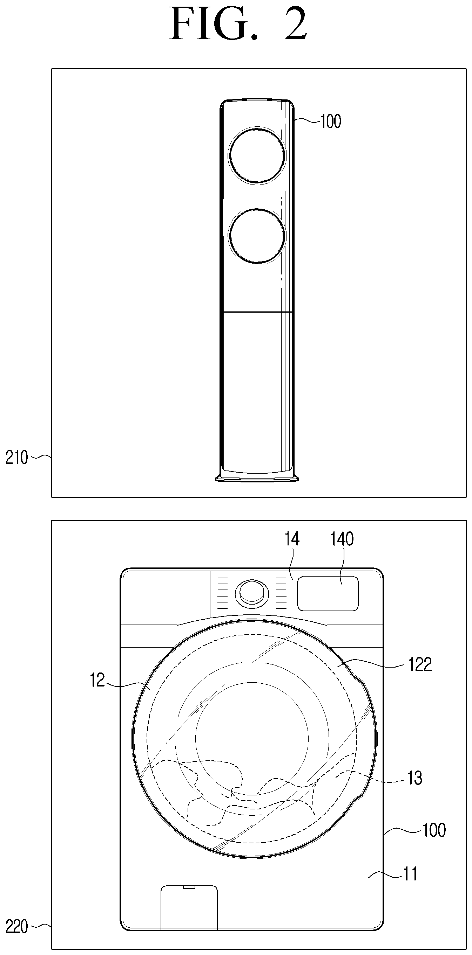

FIG 2 is a diagram for describing the electronic device 100 according to an embodiment.

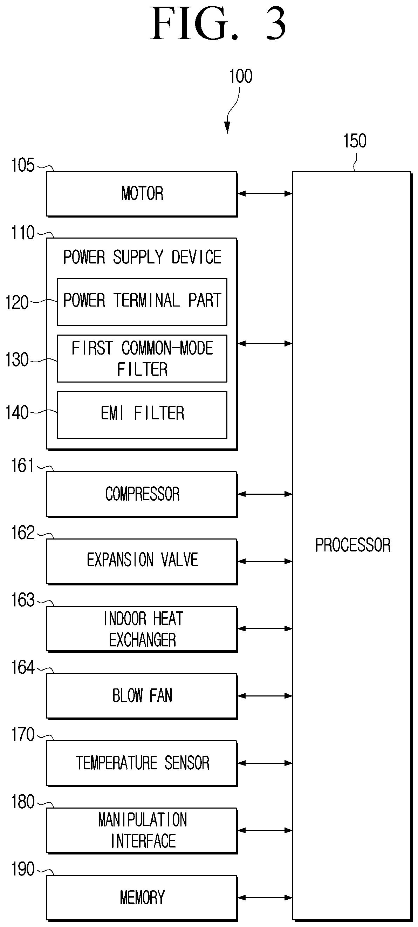

Referring to Embodiment 210 of FIG 2, the electronic device 100 may be implemented as an air conditioner (or an air conditioning control device). The electronic device 100 may be an air conditioning control device including the cooling or heating function, and the electronic device 100 may include the EMI filter 140. An embodiment related to the air conditioner is described with reference to FIG. 3.

Referring to Embodiment 220 of FIG 2, the electronic device 100 may be implemented as a dryer or a washing machine. The electronic device 100 may include the EMI filter 140.

The electronic device 100 may include a cabinet 11, a door 12, a drum 122, a manipulation panel 14, and a display.

Referring to FIG 10 showing the electronic device 100, the electronic device 100 may be a device for drying an object to be dried 13 that is already washed. The object to be dried 13 may be clothing, bedding, towels, or the like, and is not limited thereto. The object to be dried 13 may be expressed as an object to be dried.

The electronic device 100 may include an air circulation device (not shown) for circulating air in the drum 122 and a hot air supply device (not shown) for heating medium-temperature and high-humidity air discharged from the drum 122 to make high-temperature and low-humidity air. For example, the object to be dried 13 already washed and damp, may be dried in the drum 122 of the electronic device 100 based on the operations of the air circulating device and the hot air supply device.

To effectively dry the object to be dried, the drum 122 may be rotated continuously to enable the object to be dried to be in even/uniform contact with high-temperature and low-humidity air.

The cabinet 11 may include an inlet disposed on the front for inserting and removing the object to be dried 13. The door 12 may be hinge-coupled with the front of the cabinet 11 to open and close the inlet of the cabinet 11.

The manipulation panel 14 capable of controlling the electronic device 100 may be disposed on a front upper portion of the cabinet 11. The manipulation panel 14 may include the display capable of indicating a state of the electronic device 100. The user may operate the electronic device 100 by manipulating the manipulation panel 14. The manipulation panel 14 may correspond to a user interface. The manipulation panel 14 may be implemented as a circular dial or as a touch panel.

The drum 122 may be rotatably installed inside the cabinet 11, and one end of the drum 122 may communicate with the inlet of the cabinet 11.

A sensing device according to an embodiment of the present disclosure may be introduced into the drum 122 through the inlet of the electronic device 100.

Although FIG 2 shows that the electronic device 100 is implemented as the air conditioner, the dryer, or the washing machine, the electronic device 100 may be a variety of electronic devices that generate noise.

FIG 3 is a block diagram for describing the electronic device 100 according to an embodiment.

Referring to FIG 3, the electronic device 100 may be implemented as the air conditioning control device.

The electronic device 100 may include at least one of the motor 105, the power supply device 110, at least one processor 150, a compressor 161, an expansion valve 162, an indoor heat exchanger 163, a blow fan 164, a temperature sensor 170, a manipulation interface 180, and a memory 190.

The electronic device 100 in FIG 3 may correspond to the electronic device 100 in FIG 1. Therefore, a redundant description thereof is omitted.

A processor 150 may perform overall control operations of the electronic device 100. In detail, the processor 150 may function to control the overall operations of the electronic device 100.

The processor 150 may be implemented as a digital signal processor (DSP), a microprocessor, or a time controller (TCON). However, the processor 150 is not limited thereto, and may include at least one of a central processing unit (CPU), a micro controller unit (MCU), a micro processing unit (MPU), a controller, an application processor (AP), a graphics-processing unit (GPU), a communication processor (CP), or an advanced reduced instruction set computer (RISC) machine (ARM), or may be defined by these terms. The processor 150 may be implemented in a system-on-chip (SoC) or a large scale integration (LSI), in which a processing algorithm is embedded, or may be implemented in the form of a field programmable gate array (FPGA). The processor 150 may perform various functions by executing computer executable instructions stored in the memory 190.

The compressor 161 may compress the refrigerant. The compressor 161 may be driven by the motor 105. Based on the rotation of the motor 105, the compressor 161 may discharge the high-pressure refrigerant by applying a strong pressure to the refrigerant in a gaseous state. The refrigerant compressed by the compressor 161 may become the high-temperature refrigerant.

The high-temperature refrigerant may discharge heat through the outdoor heat exchanger (or a condenser). The outdoor heat exchanger may be the outdoor heat exchanger. If heat is discharged through the outdoor heat exchanger, the refrigerant may be converted into a liquid state. The refrigerant in a liquid state may pass through the expansion valve 162.

The expansion valve 162 may reduce a refrigerant pressure. The expansion valve 162 may depressurize the refrigerant in a liquid state. The expansion valve 162 may depressurize the refrigerant by allowing the refrigerant to pass through a narrow flow path. The expansion valve 162 may adjust an amount of refrigerant. The expansion valve 162 may adjust the amount of refrigerant by adjusting an opening degree. The depressurized refrigerant may be transferred to the indoor heat exchanger 163.

The indoor heat exchanger 163 may condense the received refrigerant to convert the refrigerant into the gaseous state. As the refrigerant is converted into the gaseous state, the refrigerant may absorb heat from surroundings. As heat is absorbed, air surrounding the indoor heat exchanger 163 may be cooled. The indoor heat exchanger 163 may be referred to as an evaporator. The refrigerant in a gaseous state may be moved to the compressor 161. A process of converting the state of the refrigerant / the refrigerant state may be repeated.

The blow fan 164 may discharge cooled air around the indoor heat exchanger 163 to the outside of the electronic device 100. The blow fan 164 may include at least one fan.

The temperature sensor 170 may be a sensor for measuring a temperature inside or outside the electronic device 100. The temperature sensor 170 may measure a temperature surrounding the electronic device 100. The temperature sensor 170 may measure a temperature of air discharged through the blow fan 164. The temperature sensor 170 may include a thermistor, which is a resistor whose resistance value changed based on a change in temperature. The temperature sensor 170 may transfer a sensed value to at least one processor 150.

The manipulation interface 180 may be implemented as a device such as a button, a touch pad, a mouse, or a keyboard, or may also be implemented as a touchscreen capable of performing the display function and manipulation input function described above. The button may be any of various types of buttons such as a mechanical button, a touchpad, a wheel, or the like, which is disposed in any region, such as its front surface portion, side surface portion, or rear surface portion of a body appearance of the electronic device 100.

The memory 190 may be implemented as an internal memory such as a read only memory (ROM) (for example, an electrically erasable programmable read-only memory (EEPROM)), a random access memory (RAM, or the like included in the processor 150, or may be implemented as a separate memory from the processor 150. In this case, the memory 190 may be implemented as a memory embedded in the electronic device 100 or as a memory detachably attached to the electronic device 100, based on a purpose of data storage. For example, data for operating the electronic device 100 may be stored in the memory embedded in the electronic device 100, and data for expanded functions of the electronic device 100 may be stored in the memory detachably attached to the electronic device 100.

The memory embedded in the electronic device 100 may be implemented as at least one of a volatile memory (e.g., a dynamic random access memory (DRAM), a static RAM (SRAM), or a synchronous dynamic RAM (SDRAM)), or a non-volatile memory (e.g., an one time programmable read only memory (OTPROM), a programmable ROM (PROM), an erasable and programmable ROM (EPROM), an electrically erasable and programmable ROM (EEPROM), a mask ROM, or a flash ROM), a flash memory (e.g., a NAND flash or a NOR flash), a hard drive, or a solid state drive (SSD)). In addition, the memory detachably attached to the electronic device 100 may be implemented in the form of a memory card (e.g., a compact flash (CF), a secure digital (SD), a micro secure digital (Micro-SD), a mini secure digital (Mini-SD), an extreme digital (xD), or a multi-media card (MMC)), or an external memory which may be connected to a universal serial bus (USB) port (e.g., a USB memory).

Although the description describes the cooling function with reference to FIG 3, the electronic device 100 may also perform the heating function.

FIG 4 is a diagram for describing the power supply device 110 according to an embodiment.

Referring to Embodiment 410 of FIG 4, the power supply device 110 may include at least one of the EMI filter 140, the first common-mode filter 130, or the power terminal part 120.

The power supply device 110 may include at least one of the first input terminal Li, the second input terminal Ni, the third input terminal Ei, the first output terminal Lo, the second output terminal No, or the third output terminal Eo.

The first input terminal Li, the second input terminal Ni, and the third input terminal Ei of the power supply device 110 may be included in an input terminal part of the power supply device 110.

The first output terminal Lo, the second output terminal No, and the third output terminal Eo of the power supply device 110 may be included in an output terminal part of the power supply device 110.

The power terminal part 120 may include at least one of the first terminal Li, the second terminal Ni, or the third terminal Ei.

The first terminal Li of the power terminal part 120 may be referred to as the first input terminal of the power supply device 110.

The second terminal Ni of the power terminal part 120 may be referred to as the second input terminal of the power supply device 110.

The third terminal Ei of the power terminal part 120 may be referred to as the third input terminal of the power supply device 110.

The power terminal part 120 may be referred to as the input terminal part.

The first common-mode filter 130 may include at least one of a first input terminal i1, a second input terminal i2, a third input terminal i3, a first output terminal o1, a second output terminal o2, and a third output terminal o3.

The EMI filter 140 may include at least one of a first input terminal i4, a second input terminal i5, a third input terminal i6, a first output terminal o4, a second output terminal o5, and a third output terminal o6.

The first input terminal i1 of the first common-mode filter 130 may be connected to the first terminal Li of the power terminal part 120 via a node n1.

The second input terminal i2 of the first common-mode filter 130 may be connected to the second terminal Ni of the power terminal part 120 via a node n2.

The third input terminal i3 of the first common-mode filter 130 may be connected to the third terminal Ei of the power terminal part 120 via a node n3.

The first output terminal o1 of the first common-mode filter 130 may be connected to the first input terminal i4 of the EMI filter 140 via a node n4.

The second output terminal o2 of the first common-mode filter 130 may be connected to the second input terminal i5 of the EMI filter 140 via a node n5.

The third output terminal o3 of the first common-mode filter 130 may be connected to the third input terminal i6 of the EMI filter 140 via a node n6.

The first output terminal o4 of the EMI filter 140 may be connected to the first output terminal Lo of the power supply device 110 via a node n7.

The second output terminal o5 of EMI filter 140 may be connected to the second output terminal No of the power supply device 110 via a node n8.

The third output terminal o6 of EMI filter 140 may be connected to the third output terminal Eo of the power supply device 110 via a node n9.

FIG 5 is a diagram for describing the power supply device 110 according to an embodiment.

Referring to Embodiment 510 of FIG 5, the power supply device 110 may include at least one of the EMI filter 140, the first common-mode filter 130, or the power terminal part 120. The power supply device 110 in FIG 5 may correspond to the power supply device 110 in FIG 4. Therefore, a redundant description thereof is omitted.

The EMI filter 140 may include at least one of the X capacitor section 141, the second common-mode filter 142, or the Y capacitor section 143.

The X capacitor section 141 may include at least one of a first input terminal i7, the second input terminal i8, a first output terminal o7, or a second output terminal o8.

The second common-mode filter 142 may include at least one of a first input terminal i9, a second input terminal i10, a first output terminal o9, or a second output terminal o10.

The Y capacitor section 143 may include at least one of a first input terminal i11, a second input terminal i12, a third input terminal i13, a first output terminal o11, a second output terminal o12, or a third output terminal o13.

The first output terminal o1 of the first common-mode filter 130 may be connected to the first input terminal i7 of the X capacitor section 141 via the node n4.

The second output terminal o2 of the first common-mode filter 130 may be connected to the second input terminal i8 of the X capacitor section 141 via the node n4.

The third output terminal o3 of the first common-mode filter 130 may be connected to the third input terminal i13 of the Y capacitor section 143 via the node n6.

The first output terminal o7 of the X capacitor section 141 may be connected to the first input terminal i9 of the second common-mode filter 142.

The second output terminal o8 of the X capacitor section 141 may be connected to the second input terminal i10 of the second common-mode filter 142.

The first output terminal o9 of the second common-mode filter 142 may be connected to the first input terminal i11 of the Y capacitor section 143.

The second output terminal o10 of the second common-mode filter 142 may be connected to the first input terminal i12 of the Y capacitor section 143.

The first output terminal o11 of the Y capacitor section 143 may be connected to the first output terminal Lo of the power supply device 110 via the node n7.

The second output terminal o12 of the Y capacitor section 143 may be connected to the second output terminal No of the power supply device 110 via the node n8.

The third output terminal o13 of the Y capacitor section 143 may be connected to the third output terminal Eo of the power supply device 110 via the node n9.

The first input terminal i4 of the EMI filter 140 in FIG 4 may be connected to the first input terminal i7 of the X capacitor section 141 via the node n4.

The second input terminal i5 of the EMI filter 140 in FIG 4 may be connected to the second input terminal i8 of the X capacitor section 141 via the node n5.

The third input terminal i6 of the EMI filter 140 in FIG 4 may be connected to the third input terminal i13 of the Y capacitor section 143 via the node n6.

The first output terminal o4 of the EMI filter 140 in FIG 4 may be connected to the first output terminal o11 of the Y capacitor section 143 via the node n7.

The second output terminal o5 of the EMI filter 140 in FIG 4 may be connected to the second output terminal o12 of the Y capacitor section 143 via the node n8.

The third output terminal o6 of the EMI filter 140 in FIG 4 may be connected to the third output terminal o13 of the Y capacitor section 143 via the node n9.

The arrangement of the X capacitor section 141, the second common-mode filter 142, or the Y capacitor section 143 included in the EMI filter 140 may be different. As an example, the X capacitor section 141, the second common-mode filter 142, or the Y capacitor section 143 may be implemented to have a different structure from an arrangement structure shown in FIG 5.

The EMI filter 140 in FIG 5 is described as including only one X capacitor section 141, the second common-mode filter 142, or the Y capacitor section 143. According to an implementation example, the EMI filter 140 may include at least one X capacitor section 141, at least one second common-mode filter 142, or at least one Y capacitor section 143.

As an example, the EMI filter 140 may include two or more X capacitor sections. A detailed description thereof is described with respect to FIG 11.

As an example, the EMI filter 140 may include two or more second common-mode filters 142.

As an example, the EMI filter 140 may include two or more Y capacitor sections 143.

FIG 6 is a diagram for describing the power supply device 110 according to an embodiment.

Referring to Embodiment 610 of FIG 6, the power supply device 110 may include at least one of the EMI filter 140, the first common-mode filter 130, or the power terminal part 120. The power supply device 110 in FIG 6 may correspond to the power supply device 110 in FIG 4 or 5. Therefore, a redundant description thereof is omitted.

The first common-mode filter 130 may include at least one of the first inductor L1, the second inductor L2, or the third inductor L3.

The X capacitor section 141 may include the first capacitor C1.

The second common-mode filter 142 may include at least one of the fourth inductor L4 or the fifth inductor L5.

The Y capacitor section 143 may include at least one of the second capacitor C2 or the third capacitor C3.

One end i14 of the first inductor L1 may be connected to the first terminal Li of the power terminal part 120 via the node n1. The first terminal Li of the power terminal part 120 may be the first input terminal Li of the power supply device 110.

One end i15 of the second inductor L2 may be connected to the second terminal Ni of the power terminal part 120 via the node n2. The second terminal Ni of the power terminal part 120 may be the second input terminal Ni of the power supply device 110.

One end i16 of the third inductor L3 may be connected to the third terminal Ei of the power terminal part 120 via the node n3. The third terminal Ei of the power terminal part 120 may be the third input terminal Ei of the power supply device 110.

The other end o14 of the first inductor L1 may be connected to at least one of one end i17 of the first capacitor C1 or one end i18 of the fourth inductor L4 via the node n4.

As an example, the other end o14 of the first inductor L1 may be connected in common to one end i17 of the first capacitor C1 and one end i18 of the fourth inductor L4 via the node n4.

The other end o15 of the second inductor L2 may be connected to at least one of the other end o17 of the first capacitor C1 or one end i19 of the fifth inductor L5 via the node n5.

As an example, the other end o15 of the second inductor L2 may be connected in common to the other end o17 of the first capacitor C1 and one end i19 of the fifth inductor L5 via the node n5.

The other end o16 of the third inductor L3 may be connected to at least one of the other end o20 of the second capacitor C2, one end i21 of the third capacitor C3, or the third output terminal Eo of the power supply device 110 via the node n6. The node n6 may be the same node as the node n9.

As an example, the other end o16 of the third inductor L3 may be connected in common to the other end o20 of the second capacitor C2, one end i21 of the third capacitor C3, and the third output terminal Eo of the power supply device 110 via the node n6.

The other end o18 of the fourth inductor L4 may be connected to at least one of one end i20 of the second capacitor C2 or the first output terminal Lo of the power supply device 110 via the node n7.

As an example, the other end o18 of the fourth inductor L4 may be connected in common to one end i20 of the second capacitor C2 and the first output terminal Lo of the power supply device 110 via the node n7.

The other end o19 of the fifth inductor L5 may be connected to at least one of the other end o21 of the third capacitor C3 or the second output terminal No of the power supply device 110 via the node n8.

As an example, the other end o19 of the fifth inductor L5 may be connected in common to the other end o21 of the third capacitor C3 and the second output terminal No of the power supply device 110 via the node n8.

The first input terminal i1 of the first common-mode filter 130 in FIG 5 may be connected to one end i14 of the first inductor L1.

The second input terminal i2 of the first common-mode filter 130 in FIG 5 may be connected to one end i15 of the second inductor L2.

The third input terminal i3 of the first common-mode filter 130 in FIG 5 may be connected to one end i16 of the third inductor L3.

The first output terminal o1 of the first common-mode filter 130 in FIG 5 may be connected to the other end o14 of the first inductor L1.

The second output terminal o2 of the first common-mode filter 130 in FIG 5 may be connected to the other end o15 of the second inductor L2.

The third output terminal o3 of the first common-mode filter 130 in FIG 5 may be connected to the other end o16 of the third inductor L3.

The first input terminal i7 and the first output terminal o7 of the X capacitor section 141 in FIG 5 may be connected to one end i17 of the first capacitor C1.

The second input terminal i8 and the second output terminal o8 of the X capacitor section 141 in FIG 5 may be connected to the other end o17 of the first capacitor C1.

The first input terminal i9 of the second common-mode filter 142 in FIG. 5 may be connected to one end i18 of the fourth inductor L4.

The second input terminal i10 of the second common-mode filter 142 in FIG 5 may be connected to one end i19 of the fifth inductor L5.

The first output terminal o9 of the second common-mode filter 142 in FIG 5 may be connected to the other end o18 of the fourth inductor L4.

The second output terminal o10 of the second common-mode filter 142 in FIG 5 may be connected to the other end o19 of the fifth inductor L5.

The first input terminal i111 and the first output terminal o11 of the Y capacitor section 143 in FIG 5 may be connected to one end i20 of the second capacitor C2 via the node n7.

The second input terminal i12 and the second output terminal o12 of the Y capacitor section 143 in FIG 5 may be connected to the other end o21 of the third capacitor C3 via the node n8.

The third input terminal i13 and the third output terminal o13 of the Y capacitor section 143 in FIG 5 may be connected in common to the other end o20 of the second capacitor C2 and one end i21 of the third capacitor C3 via the node n9.

FIG 7 is a diagram for describing the power supply device 110 according to an embodiment.

The power supply device 110 of Embodiment 710 of FIG. 7 may include the power terminal part 120 and the EMI filter 140.

The EMI filter 140 may include at least one of the first common-mode filter 130, the X capacitor section 141, the second common-mode filter 142, or the Y capacitor section 143. A description of each component may correspond to those provided with reference to in FIGS. 4 to 6. Therefore, a redundant description thereof is omitted.

In the descriptions provided with reference to FIGS. 4 to 6, the first common-mode filter 130 is described as being disposed outside the EMI filter 140. According to an embodiment, the first common-mode filter 130 may be disposed inside the EMI filter 140. That is, the first common-mode filter 130 may be included in the EMI filter 140.

FIG 8 is a diagram for describing the power supply device 110 according to an embodiment.

Embodiment 810 of FIG 8 may correspond to Embodiment 610 of FIG 6. Therefore, a redundant description thereof is omitted.

The EMI filter 140 may include at least one of the X capacitor section 141, the second common-mode filter 142, the Y capacitor section 143, or the differential-mode filter 144.

The differential-mode filter 144 may include a sixth inductor L6.

One end i22 of the sixth inductor L6 may be connected to at least one of one end i20 of the second capacitor C2 or the other end o18 of the fourth inductor L4 via a node n10.

As an example, one end i22 of the sixth inductor L6 may be connected in common to one end i20 of the second capacitor C2 and the other end o18 of the fourth inductor L4 via the node n10.

The other end o22 of the sixth inductor L6 may be connected to the first output terminal Lo of the power supply device 110 via the node n7.

The other end o18 of the fourth inductor L4 may be connected to at least one of one end i20 of the second capacitor C2 or one end i22 of the sixth inductor L6 via the node n10.

As an example, the other end o18 of the fourth inductor L4 may be connected in common to one end i20 of the second capacitor C2 and one end i22 of the sixth inductor L6 via the node n10.

FIG 9 is a diagram for describing the power supply device 110 according to an embodiment.

Embodiment 910 of FIG 9 may correspond to Embodiment 810 of FIG 8. Therefore, a redundant description thereof is omitted.

The differential-mode filter 144 may include at least one of the sixth inductor L6 or a seventh inductor L7.

One end i23 of the seventh inductor L7 may be connected to at least one of the other end o21 of the third capacitor C3 or the other end o19 of the fifth inductor L5 via a node n11.

As an example, one end i23 of the seventh inductor L7 may be connected in common to the other end o21 of the third capacitor C3 and the other end o19 of the fifth inductor L5 via the node n11.

The other end o23 of the seventh inductor L7 may be connected to the second output terminal No of the power supply device 110 via the node n9.

The other end o19 of the fifth inductor L5 may be connected to at least one of the other end o21 of the third capacitor C3 or one end i23 of the seventh inductor L7 via the node n11.

As an example, the other end o19 of the fifth inductor L5 may be connected in common to the other end o21 of the third capacitor C3 and one end i23 of the seventh inductor L7 via the node n11.

FIG 10 is a diagram for describing the power supply device 110 according to an embodiment.

Embodiment 1010 of FIG 10 may correspond to Embodiment 610 of FIG 6. Therefore, a redundant description thereof is omitted.

The EMI filter 140 may include the switch S1.

One end i24 of the switch S1 may be connected to the other end o16 of the third inductor L3 via the node n6.

The other end o24 of the switch S1 may be connected to the third output terminal Eo of the power supply device 110 via the node n9.

The power supply device 110 may control the turning on/off of the switch S1 based on the predetermined event.

In a general situation, the power supply device 110 may turn off the switch S1 to maintain a state in which the node n9 and the node n6 are disconnected from each other.

As an example, the power supply device 110 may turn on the switch S1 to connect the node n9 to the node n6 based on at least one of the noise current magnitude or the noise voltage magnitude.

The power supply device 110 may identify the noise current magnitude or the noise voltage magnitude.

If the noise current magnitude is greater than or equal to the first threshold value, the power supply device 110 may turn on the switch S1 to connect the node n9 to the node n6.

If the noise voltage magnitude is greater than or equal to the second threshold value, the power supply device 110 may turn on the switch S1 to connect the node n9 to the node n6.

If the noise current magnitude is greater than or equal to the first threshold value and the noise voltage magnitude is greater than or equal to the second threshold value, the power supply device 110 may turn on the switch S1 to connect the node n9 to the node n6.

The first threshold value and the second threshold value may be different from each other.

The power supply device 110 may measure the noise current at least one of the node n4 or the node n5.

The power supply device 110 may measure the noise voltage based on a voltage difference between the node n4 and the node n5.

As an example, the power supply device 110 may turn on the switch S1 based on the user input to connect the node n9 to the node n6.

As an example, the power supply device 110 may turn on the switch S1 based on a noise audio level to connect the node n9 to the node n6.

The electronic device 100 may include a speaker. The electronic device 100 may output noise audio through the speaker. The electronic device 100 may include a microphone. The electronic device 100 may receive (or obtain) the noise audio through the microphone. The electronic device 100 may identify the received noise audio level.

A mode in which the switch is operated in a turned-off state may be described as a first mode (or general mode). A mode in which the switch is operated in a turned-on state may be described as a second mode (or noise removal mode).

FIG 11 is a diagram for describing the power supply device 110 according to an embodiment.

Embodiment 1110 of FIG. 11 may correspond to Embodiment 610 of FIG 6. Therefore, a redundant description thereof is omitted.

The EMI filter 140 may include at least one of the X capacitor section 141, the second common-mode filter 142, the Y capacitor section 143, or the second X capacitor section 145. The X capacitor section 141 may be referred to as the first X capacitor section 141.

The second X capacitor section 145 may include a fourth capacitor C4.

One end i24 of the fourth capacitor C4 may be connected to at least one of the first output terminal Lo of the power supply device 110, one end i20 of the second capacitor C2, or the other end o18 of the fourth inductor L4 via the node n7.

As an example, one end i24 of the fourth capacitor C4 may be connected in common to the first output terminal Lo of the power supply device 110, one end i20 of the second capacitor C2, and the other end o18 of the fourth inductor L4 via the node n7.

The other end o18 of the fourth inductor L4 may be connected to at least one of the first output terminal Lo of the power supply device 110, one end i24 of the fourth capacitor C4, or one end i20 of the second capacitor C2 via the node n7.

As an example, the other end o18 of the fourth inductor L4 may be connected in common to the first output terminal Lo of the power supply device 110, one end i24 of the fourth capacitor C4, and one end i20 of the second capacitor C2 via the node n7.

The other end o24 of the fourth capacitor C4 may be connected to at least one of the second output terminal No of the power supply device 110, the other end o21 of the third capacitor C3, or the other end o19 of the fifth inductor L5 via the node n8.

As an example, the other end o24 of the fourth capacitor C4 may be connected in common to the second output terminal No of the power supply device 110, the other end o21 of the third capacitor C3, and the other end o19 of the fifth inductor L5 via the node n8.

The other end o19 of the fifth inductor L5 may be connected to at least one of the second output terminal No of the power supply device 110, the other end o24 of the fourth capacitor C4, or the other end o21 of the third capacitor C3 via the node n8.

As an example, the other end o19 of the fifth inductor L5 may be connected in common to the second output terminal No of the power supply device 110, the other end o24 of the fourth capacitor C4, and the other end o21 of the third capacitor C3 via the node n8.

FIG 12 is a diagram for describing an operation for providing noise information.

Referring to FIG 12, the electronic device 100 may provide a screen 1200 for providing the noise information. The electronic device 100 may include the display. The electronic device 100 may display the screen 1200 on the display.

The screen 1200 may include at least one of a user interface (UI) 1210 including text indicating noise detection, a UI 1220 including an image indicating noise detection, a UI 1230 indicating a noise magnitude, a UI 1240 for guiding the noise removal mode, a UI 1250 including information indicating an automatic execution function of the noise removal mode, or a UI 1260 including information indicating a power-off function.

The UI 1240 for guiding the noise removal mode may include text that queries the user whether to perform the noise removal mode. The electronic device 100 may receive (or obtain) the user input through the UI 1240.

The electronic device 100 may generate the screen 1200 if noise is detected.

As an example, the electronic device 100 may display the screen 1200 on the display included in the electronic device 100.

As an example, the electronic device 100 may transmit the screen 1200 to a display of the external device connected to the electronic device 100. The external device may display the screen 1200 received from the electronic device 100 on the display of the external device.

FIG 13 is a diagram for describing a noise path.

Referring to Embodiment 1310 of FIG 13, the electronic device 100 may be connected to an external power supply 200. The external power supply 200 may be a terminal for supplying external power. The external power supply 200 may be referred to as a power line or a power supply section.

According to an embodiment, a differential-mode current may be generated depending on the connection between the electronic device 100 and the external power supply 200. The differential-mode current may indicate current flowing from the electronic device 100 to the external power supply 200 through an L line and current flowing from the external power supply 200 to the electronic device 100 through an N line. The differential-mode current may flow through the L line in a first direction and flow through the N line in a second direction opposite to the first direction.

According to an embodiment, the common-mode current may be generated depending on the connection between the electronic device 100 and the external power supply 200. A plurality of common-mode currents may be present.

A first common-mode current may indicate current flowing from the electronic device 100 to the external power supply 200 through the L line, current flowing from the electronic device 100 to the external power supply 200 through the N line, and current flowing from the external power supply 200 to the electronic device 100 through an E line. The first common-mode current may flow through the L and N lines in the first direction, and flow through the E line in the second direction opposite to the first direction.

A second common-mode current may indicate current flowing from the electronic device 100 to the external power supply 200 through the L line, current flowing from the electronic device 100 to the external power supply 200 through the N line, and current flowing from the electronic device 100 to the external power supply 200 through the E line. The second common-mode current may flow in the L, N, and E lines in the first direction (the same direction).

The first common-mode current may be referred to as a first type of common-mode current. The second common-mode current may be referred to as a second type of common-mode current.

The L line may be connected to the first input terminal Li of the power supply device 110.

The N line may be connected to the second input terminal Ni of the power supply device 110.

The E line may be connected to the third input terminal Ei of the power supply device 110.

FIG 14 is a diagram for describing an arrangement of the EMI filter 140.

Embodiment 1410 of FIG 14 shows that the motor 105 and the EMI filter 140 are connected to each other via the L and N lines. The EMI filter 140 of Embodiment 1410 may have difficulty in removing the common-mode current having various flows.

As an example, the EMI filter 140 may have difficulty in removing the second common-mode current described with reference to FIG 13. The EMI filter 140 of Embodiment 1410 may have difficulty in removing current 1411 flowing from the electronic device 100 to the external power supply 200 through the E line among the second common-mode current shown in FIG 13.

Embodiment 1420 of FIG 14 shows that the motor 105 and the EMI filter 140 are connected to each other via the L and N lines, and the first common-mode filter 130 is connected to the power supply unit 120 via the L, N, and E lines. The first common-mode filter 130 may remove the common-mode current having various flows.

As an example, the first common-mode filter 130 may remove the current 1411 flowing from the electronic device 100 to the external power supply 200 through the E line among the second common-mode current shown in FIG. 13.

The E line may indicate a virtual line flowing through the ground rather than an actual physical wire connected to the power supply unit 120.

FIG 15 is a diagram for describing the EMI filter that does not include a three-terminal common-mode filter and disturbance current according to an embodiment.

Embodiment 1510 of FIG 15 shows the EMI filter 140 that is not connected to the E line. The power supply device 110 may include at least one of the power terminal part 120 or the EMI filter 140.

The EMI filter 140 may include at least one of the X capacitor 141, the second common-mode filter 142, or a Y capacitor 143.

Embodiment 1520 of FIG. 15 shows a flow of the common-mode current flowing through the EMI filter 140 of Embodiment 1510.

The common-mode current shown in FIG 15 may be the second common-mode current shown in FIG. 13.

Referring to Embodiment 1520 of FIG 15, the EMI filter 140 of Embodiment 1510 may remove the common-mode current flowing through the L and N lines. The EMI filter 140 of Embodiment 1510 may not remove the common-mode current flowing through the E line.

Therefore, the common-mode current flowing through the E line in Embodiment 1520 may be emitted without being removed (or limited). The disturbance current may indicate the common-mode current.

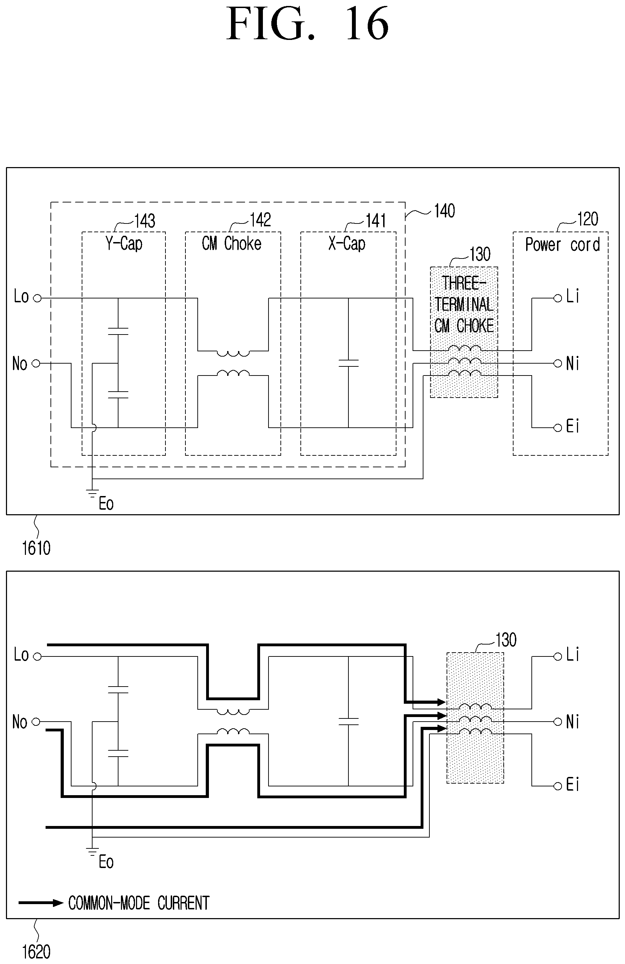

FIG 16 is a diagram for describing the EMI filter 140 that includes the three-terminal common-mode filter and the disturbance current according to an embodiment.

Referring to Embodiment 1610 of FIG 16, the power supply device 110 may include at least one of the power terminal part 120, the first common-mode filter 130, or the EMI filter 140. The first common-mode filter 130 may be the three-terminal common-mode filter.

The EMI filter 140 may include at least one of the X capacitor 141, the second common-mode filter 142, or the Y capacitor 143.

Embodiment 1620 of FIG. 16 shows a flow of the common-mode current flowing through the EMI filter 140 of Embodiment 1610.

The common-mode current shown in FIG 16 may be the second common-mode current shown in FIG 13.

Referring to Embodiment 1620 of FIG 16, the EMI filter 140 of Embodiment 1610 may remove the common-mode current flowing through the L, N, and E lines. The EMI filter 140 of Embodiment 1610 may remove the second common-mode current shown in FIG 13 that flows through the L, N, and E lines in the same direction.

The power supply device 110 may be designed to correspond even to conducted emission (CE) and disturbance power (DP) from an existing EMI filter used to correspond only to the conducted emission (CE) by using a the disturbance power corresponding element (e.g., the first common-mode filter 130). The designed power supply device 110 may improve noise removal efficiency.

The power supply device 110 may include the first common-mode filter 130 for corresponding to the disturbance power (DP). The first common-mode filter 130 may include a three-terminal common-mode choke.

The L, N, and E lines may commonly pass through the first common-mode filter 130.

The first common-mode filter 130 may function to limit a common-mode component in each of the L, N, and E lines.

A power cord of the existing EMI filter may be connected only to the L and N lines, and the E line may be connected to a case (or chassis) of a product. The Y capacitor section 143 of the existing EMI filter may be connected to the case (or chassis) of the product.

The first common-mode filter 130 may limit (or absorb or remove) conducted emissions (CE) and the disturbance power (DP). The power supply device 110 including the first common-mode filter 130 may connect the E line of the power cord to the first common-mode filter 130. The Y capacitor section 143 may be connected to the case (or chassis) of the product.

The power supply device 110 may limit the emission of the common-mode current flowing from Eo to Ei through the first common-mode filter 130.

FIG 17 is a diagram for describing the second common-mode filter 142.

The second common-mode filter 142 may indicate a two-terminal common-mode choke. The second common-mode filter 142 may include a core and two windings. The core may be a circular core. The core may be a magnetic material. The two windings may be wound in the same direction.

Referring to Embodiment 1710 of FIG 17, the second common-mode filter 142 may include a core 1701, a first winding 1711, and a second winding 1712. The first winding 1711 and the second winding 1712 may be wound in the same direction.

Being wound in the same direction may indicate that both the windings 1711 and 1712 are wound from outside to inside along the same first surface of the core 1701.

The first winding 1711 and the second winding 1712 may be wound in different directions around the core 1701 relative to a direction in which a common current moves around a circular central axis of the core 1701. The first winding 1711 may be wound around the core 1701 in a clockwise direction, and the second winding 1712 may be wound around the core 1701 in a counterclockwise direction.

Referring to Embodiment 1720 of FIG 17, the second common-mode filter 142 may include a core 1702, a first winding 1721, and a second winding 1722. The first winding 1721 and the second winding 1722 may be wound in the same direction.

Being wound in the same direction may indicate that both the windings 1721 and 1722 are wound from the outside to the inside along the same first surface of the core 1702.

The first winding 1721 and the second winding 1722 may be wound in different directions around the core 1702 relative to a direction in which the common current moves around a circular central axis of the core 1702. The first winding 1721 may be wound around the core 1702 in the counterclockwise direction and the second winding 1722 may be wound around in the clockwise direction.

FIG 18 is a diagram for describing the first common-mode filter 130.

The first common-mode filter 130 may be a three-terminal common-mode choke. The three-terminal may indicate a terminal having three input terminals or three output terminals. Therefore, the first common-mode filter 130 may include three pairs of input and output terminals.

Referring to Embodiment 1810, the first common-mode filter 130 may include a core 1801, a first winding 1811, a second winding 1812, and a third winding 1813. The first winding 1811, the second winding 1812, and the third winding 1813 may be wound in the same direction.

Being wound in the same direction may indicate that all the three windings 1811, 1812, and 1813 are wound from the outside to the inside along the same first surface of the core 1801.

The first winding 1811, the second winding 1812, and the third winding 1813 may be wound in the same direction relative to a direction in which the common current moves around a circular central axis of the core 1801. The first winding 1811, the second winding 1812, and the third winding 1813 may be wound in the counterclockwise direction.

Embodiment 1820 of FIG 18 shows a side view of the first common-mode filter 130.

The first common-mode filter 130 may be designed to satisfy a withstand voltage condition between the first winding 1811 and the second winding 1812, connected to the first input terminal Li of the power terminal part and the second input terminal N9, and the third winding 1813, connected to the third input terminal Ei.

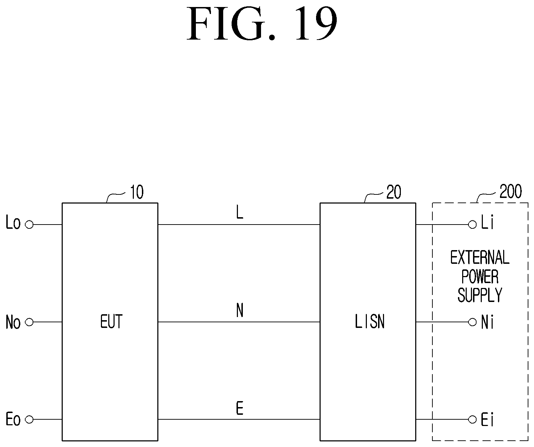

FIG 19 is a diagram for describing equipment under test (EUT) and a line impedance stabilization network (LISN).

Referring to FIG 19, equipment under test (EUT) 10 may be connected to a line impedance stabilization network (LISN) 20. The line impedance stabilization network 20 may be connected to the external power supply 200. The external power supply 200 may include three terminals Li, Ni, and Ei. The equipment under test 10 may correspond to the electronic device 100.

The equipment under test 10 may indicate a noise source. Therefore, the equipment under test 10 may be referred to as the noise source device.

The line impedance stabilization network 20 may be referred to as a power line impedance stabilization network. The line impedance stabilization network 20 may be a standard device for testing electromagnetic interference. The line impedance stabilization network 20 may provide accurate (or stable) line impedance. The line impedance stabilization network 20 may provide high impedance, thereby preventing circuit damage caused by overload.

The line impedance stabilization network 20 may be a measuring instrument for measuring electro magnetic interference (EMI) or electro magnetic compatibility (EMC). The line impedance stabilization network 20 may separate only noise by using a filter function.

One end of the line impedance stabilization network 20 may be connected to the equipment under test 10, and the other end of the line impedance stabilization network 20 may be connected to the external power supply 200.

According to an embodiment, the electronic device 100 may separate noise by adding the line impedance stabilization network 20. The electronic device 100 may analyze noise based on the separated noise.

The electronic device 100 may control the first common-mode filter 130 by using an analysis result. As an example, the electronic device 100 may measure a noise level by using the analysis result, and the electronic device 100 may perform a mode in which the switch S1 in FIG 10 is operated in the turned-on state based on the measured noise.

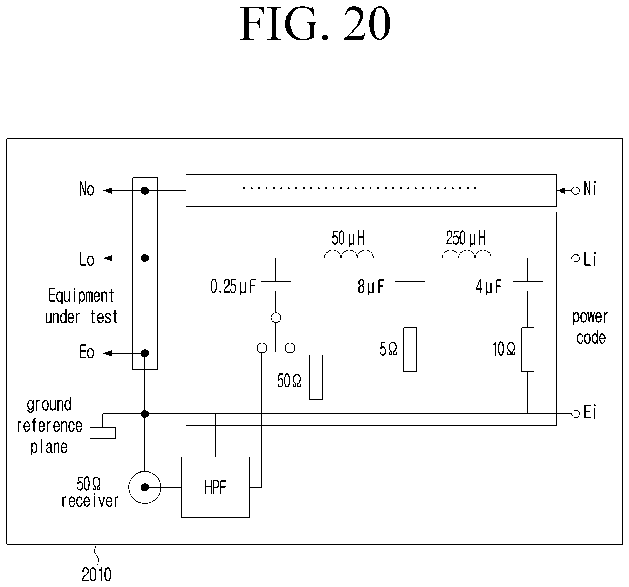

FIG 20 is a diagram for describing the line impedance stabilization network 20.

Referring to Embodiment 2010 of FIG 20, the line impedance stabilization network 20 may be a circuit network for measuring the conducted emission (CE) in a band from 9 kHz or 150 kHz to 30 MHz.

The line impedance stabilization network 20 may include at least one capacitor, at least one inductor, and at least one resistor. The line impedance stabilization network 20 may include a high-frequency filter (HPF).

Embodiment 2010 of FIG 20 shows one circuit among various circuits of the line impedance stabilization network 20. The line impedance stabilization network 20 may be implemented as a circuit other than the circuit shown in Embodiment 2010.

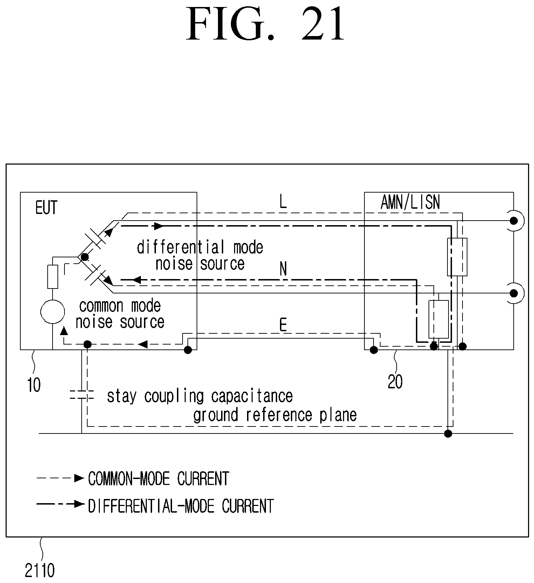

FIG 21 is a diagram for describing the disturbance current flowing through the equipment under test 10 and the line impedance stabilization network 20.

Referring to Embodiment 2110 of FIG 21, the line impedance stabilization network 20 may be connected to the equipment under test 10. The equipment under test 10 may correspond to the electronic device 100.

Noise may occur if the equipment under test 10 and the line impedance stabilization network 20 are powered. As an example, at least one of the common-mode current and the differential-mode current may occur.

The equipment under test 10 and the line impedance stabilization network 20 may be connected to each other through the L, N, and E lines. The E line may be a virtual line implemented to flow through the ground. Therefore, in reality, the E line may not be present as a separate wire.

The common-mode current may flow through the L, N, and E lines. The common-mode current may flow from the equipment under test 10 to the line impedance stabilization network 20 through the L line.

The common-mode current may flow from the equipment under test 10 to the line impedance stabilization network 20 through the N line.

The common-mode current may flow from the line impedance stabilization network 20 to the equipment under test 10 through the E line.

The differential-mode current may flow through the L and N lines. The differential-mode current may flow from the equipment under test 10 to the line impedance stabilization network 20 through the L line.

The differential-mode current may flow from the line impedance stabilization network 20 to the equipment under test 10 through the N line.

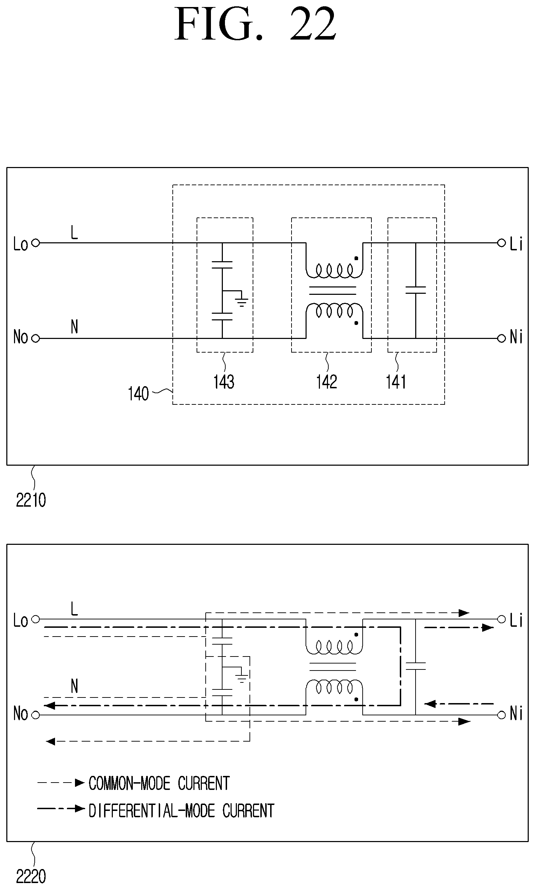

FIG 22 is a diagram for describing the EMI filter and the disturbance current according to an embodiment.

Embodiment 2210 of FIG 22 indicates the EMI filter 140. The EMI filter 140 may include at least one of the X capacitor section 141, the second common-mode filter 142, or the Y capacitor section 143.

The X capacitor 141 may bypass the differential-mode current into the product.

The second common-mode filter 142 may limit the emission of noise by blocking the flow to prevent the disturbance current from being emitted to the outside.

The Y capacitor section 143 may bypass the common-mode current into the product.

Embodiment 2220 of FIG 22 indicates noise flowing if power is supplied to the EMI filter 140 of Embodiment 2210. The EMI filter 140 of Embodiment 2210 may remove noise (the common-mode current or the differential-mode current). The EMI filter 140 may remove the common-mode current by using the second common-mode filter 142.

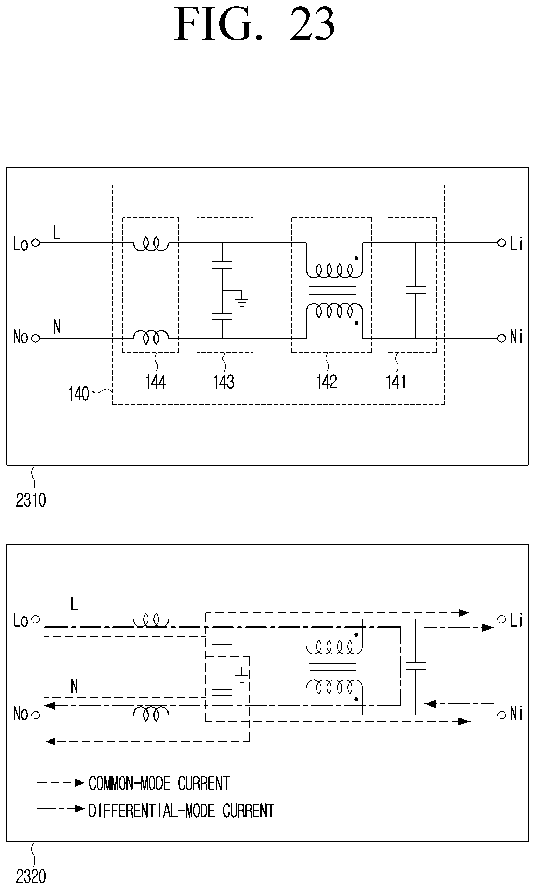

FIG 23 is a diagram for describing the EMI filter and the disturbance current according to an embodiment.

Referring to Embodiment 2310 of FIG 23, the EMI filter 140 may include at least one of the Y capacitor 143, the X capacitor 141, the second common-mode filter 142, or the differential-mode filter 144.

Embodiment 2320 of FIG 23 shows flows of the common-mode current and the differential-mode current in the EMI filter 140 of Embodiment 2310.

The EMI filter 140 may remove the common-mode current by using the second common-mode filter 142. The EMI filter 140 may remove the differential-mode current by using the differential-mode filter 144. The differential-mode filter 144 may include two inductors. According to an implementation example, the differential-mode filter 144 may include a single inductor. The single inductor may be disposed on the L line or the N line.

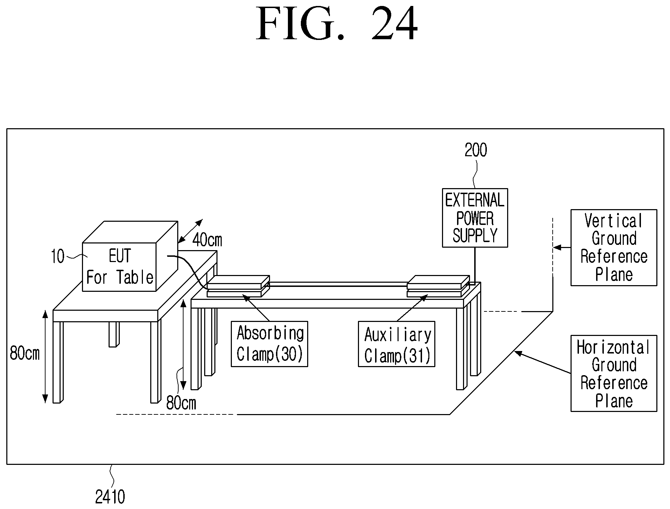

FIG 24 is a diagram for describing an operation for measuring the disturbance power.

Embodiment 2410 of FIG 24 shows a situation for measuring the disturbance power (DP). Embodiment 2410 may show a condition for measuring the disturbance power.

If a power cord is a measurement target, a measurer (or the user) may measure the power cord by passing the power cord through the absorption clamp 30.

An instrumentation current transformer (CT) of the absorption clamp 30 may measure the common-mode current simultaneously flowing through the L, N, and E lines in the power cord. The absorption clamp 30 may obtain the disturbance power by using the common-mode current. The instrumentation current transformer (CT) may be referred to as a CT sensor.

The equipment under test 10 may be connected to the external power supply 200. The absorption clamp 30 may be connected between the equipment under test 10 and the external power supply 200.

Two absorption clamps may be used to measure the disturbance power. In addition to the absorption clamp 30, an auxiliary absorption clamp 31 may be used.

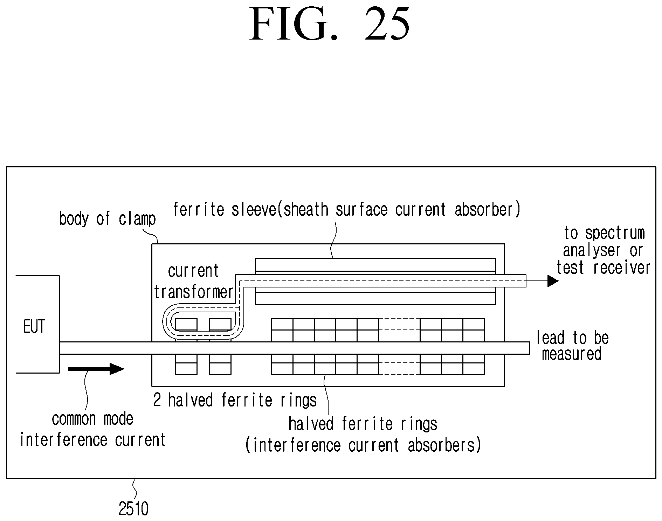

FIG 25 is a diagram for describing the absorption clamp 30.

Embodiment 2510 of FIG 25 shows a structure of the absorption clamp 30 for measuring the disturbance power in a band of 30 to 300 MHz.

The absorption clamp 30 may include at least one of the instrumentation current transformer (CT), a ferrite ring core, or a ferrite sleeve.

The instrumentation current transformer (CT) may measure the disturbance current. The ferrite ring core and the ferrite sleeve may absorb noise.

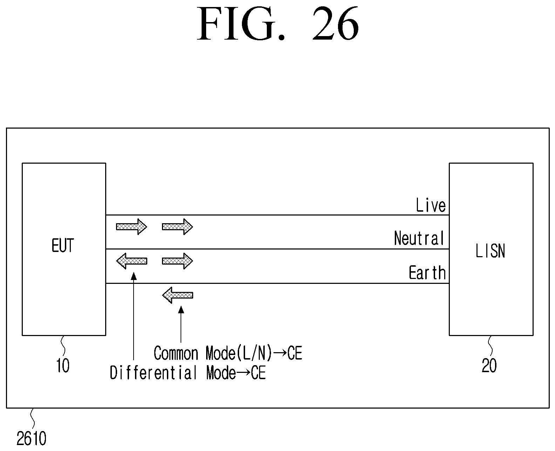

FIG 26 is a diagram for describing noise occurring if the line impedance stabilization network 20 is used.

Referring to Embodiment 2610 of FIG 26, if the equipment under test 10 is connected to the line impedance stabilization network 20, the differential-mode current and the first common-mode current may occur.

The differential-mode current in Embodiment 2610 may flow from the equipment under test 10 to the line impedance stabilization network 20 through the L line.

The differential-mode current in Embodiment 2610 may flow from the line impedance stabilization network 20 to the equipment under test 10 through the N line.

The first common-mode current in Embodiment 2610 may flow from the equipment under test 10 to the line impedance stabilization network 20 through the L line.

The first common-mode current in Embodiment 2610 may flow from the equipment under test 10 to the line impedance stabilization network 20 through the N line.

The first common-mode current in Embodiment 2610 may flow from the line impedance stabilization network 20 to the equipment under test 10 through the E line.

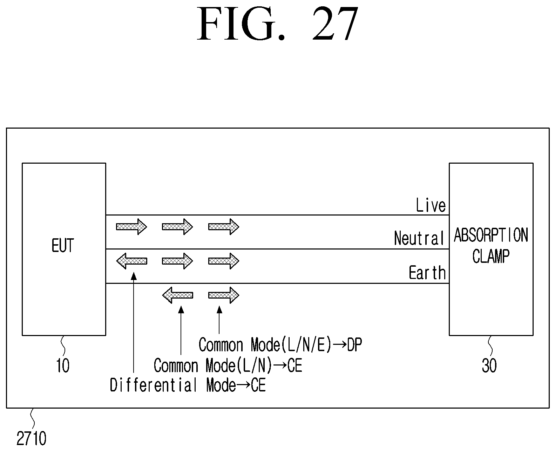

FIG 27 is a diagram for describing noise occurring if the absorption clamp 30 is used.

Referring to Embodiment 2710 of FIG 27, if the equipment under test 10 is connected to the absorption clamp 30, at least one of the differential-mode current, the first common-mode current, or the second common-mode current may occur.

The differential-mode current and the first common-mode current are described in an embodiment of FIG 26, and redundant descriptions thereof are omitted.

The second common-mode current in Embodiment 2710 may flow through the L, N, and E lines in the same direction.

The second common-mode current in Embodiment 2710 may flow from the equipment under test 10 to the line impedance stabilization network 20 through the line L.

The second common-mode current in Embodiment 2710 may flow from the equipment under test 10 to the line impedance stabilization network 20 through the N line.

The second common-mode current in Embodiment 2710 may flow from the equipment under test 10 to the line impedance stabilization network 20 through the E line.

In case of evaluating the conducted emission (CE), the differential-mode current and the first common-mode current may be used.

In case of evaluating the disturbance power (DP), the second common-mode current may be used.

As an example, the differential-mode current and the first common-mode current may be measured if the equipment under test 10 is connected to the line impedance stabilization network 20.

As an example, the second common-mode current may be measured if the equipment under test 10 is connected to the absorption clamp 30.

Noise management may be difficult if the second common-mode current is not absorbed.

The methods according to the various embodiments of the present disclosure described above may be implemented in the form of an application which may be installed on an existing electronic device.

The methods according to the various embodiments of the present disclosure described above may be implemented only by software upgrade or hardware upgrade of an existing display device.

The various embodiments of the present disclosure described above may be performed through an embedded server included in the electronic device, or an external server of at least one of the electronic device and the display device.

According to an embodiment of the present disclosure, the various embodiments described above may be implemented in software including an instruction stored on a machine-readable storage medium (for example, a computer-readable storage medium). A machine may be a device that invokes the stored instruction from a storage medium, may be operated based on the invoked instruction, and may include the electronic device according to the disclosed embodiments. If the instruction is executed by the processor, the processor may directly perform a function corresponding to the instruction or other components may perform the function corresponding to the instruction under the control of the processor. The instruction may include codes generated or executed by a compiler or an interpreter. The machine-readable storage medium may be provided in the form of a non-transitory storage medium. The term "non-transitory" indicates that the storage medium is tangible without including a signal, and does not distinguish whether data are semi-permanently or temporarily stored on the storage medium.

According to an embodiment of the present disclosure, the methods according to the various embodiments described above may be included and provided in a computer program product. The computer program product may be traded as a commodity between a seller and a purchaser. The computer program product may be distributed in a form of the machine-readable storage medium (for example, a compact disc read only memory (CD-ROM)), or may be distributed online through an application store (for example, PlayStore^{™}. In case of the online distribution, at least a portion of the computer program product may be at least temporarily stored or temporarily generated on a storage medium such as the memory of a manufacturer server, an application store server, or a relay server.

Each of the components (for example, modules or programs) according to the various embodiments described above may include a single entity or a plurality of entities, and some of the corresponding sub-components described above may be omitted or other sub-components may be further included in the various embodiments. Alternatively or additionally, some of the components (for example, the modules or the programs) may be integrated into the single entity, and may perform functions performed by the respective corresponding components before being integrated in the same or similar manner. Operations performed by the modules, the programs, or other components according to the various embodiments may be executed in a sequential manner, a parallel manner, an iterative manner, or a heuristic manner, at least some of the operations may be performed in a different order or be omitted, or other operations may be added.

Although the embodiments are shown and described in the present disclosure as above, the present disclosure is not limited to the above-described specific embodiments, and may be variously modified by those skilled in the art to which the present disclosure pertains without departing from the gist of the present disclosure as claimed in the accompanying claims. These modifications should also be understood to fall within the scope and spirit of the present disclosure.

## Claims

1. An electronic device comprising:
a motor;
a power supply device configured to supply power to the motor; and
at least one processor configured to control the motor,
wherein the power supply device includes
a power terminal part connected to a ground wire and configured to receive an alternating current (AC) power through a first input terminal, a second input terminal, and a third input terminal,
an electro magnetic interference (EMI) filter configured to remove noise included in the AC power,
a ground terminal of the power supply device, and
a first common-mode filter including a first core and first, second, and third inductors wound around the first core, and configured to connect the third input terminal, connected to the ground wire, to the ground terminal by using the third inductor, and to connect the remaining first and second input terminals to the EMI filter by using the first and second inductors, respectively.

2. The device as claimed in claim 1, wherein the first inductor, the second inductor, and the third inductor are connected in series.

3. The device as claimed in claim 1, wherein the EMI filter includes
an X capacitor section including a first capacitor,
a second common-mode filter including a second core and fourth and fifth inductors wound around the second core, and
a Y capacitor section including a second capacitor and a third capacitor connected in series.

4. The device as claimed in claim 3, wherein the power supply device includes a first output terminal, a second output terminal, and a third output terminal, connected to the Y capacitor section.

5. The device as claimed in claim 4, wherein one end of the first inductor is connected to the first input terminal of the power terminal part,
the other end of the first inductor is connected in common to one end of the first capacitor and one end of the fourth inductor,
one end of the second inductor is connected to the second input terminal of the power terminal part,
the other end of the second inductor is connected in common to the other end of the first capacitor and one end of the fifth inductor,
one end of the third inductor is connected to the third input terminal of the power terminal part, and
the other end of the third inductor is connected in common to one end of the third capacitor and the third output terminal of the power supply device.

6. The device as claimed in claim 5, wherein the other end of the fourth inductor is connected to one end of the second capacitor and the first output terminal of the power supply device,
the other end of the fifth inductor is connected to the other end of the third capacitor and the second output terminal of the power supply device, and
the other end of the third inductor is connected to the other end of the second capacitor.

7. The device as claimed in claim 1, wherein the first core is made of a magnetic material, and
the first inductor, the second inductor, and the third inductor are wound around the first core in the same direction.

8. The device as claimed in claim 3, wherein the second core is made of a magnetic material, and
the fourth inductor and the fifth inductor are wound around the second core in the same direction.

9. The device as claimed in claim 3, wherein the EMI filter includes a differential-mode filter including at least one inductor, and
the differential-mode filter is connected with the second common-mode filter and the X capacitor section.

10. The device as claimed in claim 5, wherein the other end of the third inductor is connected in common to the other end of the second capacitor, one end of the third capacitor, and the third output terminal of the power supply device via a switch.

11. The device as claimed in claim 10, wherein if a predetermined event is identified as occurring, the at least one processor is configured to turn on the switch to connect the other end of the third inductor in common to the other end of the second capacitor, one end of the third capacitor, and the third output terminal of the power supply device.

12. The device as claimed in claim 10, wherein the predetermined event is an event identified by noise greater than or equal to a threshold value.

13. The device as claimed in claim 1, wherein the motor is a brushless direct current (BLDC) motor, and is configured to receive power passing through the EMI filter.

14. The device as claimed in claim 1, further comprising a substrate on which the power terminal part, the EMI filter, and the first common-mode filter are disposed.

15. A power supply device configured to supply power to a motor, the device comprising:
a power terminal part connected to a ground wire and configured to receive an alternating current (AC) power through a first input terminal, a second input terminal, and a third input terminal;
an electro magnetic interference (EMI) filter configured to remove noise included in the AC power;
a ground terminal of the power supply device; and
a first common-mode filter including a first core and first, second, and third inductors wound around the first core, and configured to connect the third input terminal, connected to the ground wire, to the ground terminal by using the third inductor, and to connect the remaining first and second input terminals to the EMI filter by using the first and second inductors, respectively.
